# EUROPEAN PATENT SPECIFICATION

(11) **EP 0 635 817 B1**
(45) Date of publication and mention of the grant of the patent: **21.10.1998**
(21) Application number: 94116991.4
(22) Date of filing: 29.11.1989
(51) Int. Cl.: G09G 1/16

(54) **A synchronous dynamic memory**
Synchroner dynamischer Speicher
Mémoire dynamique synchrone

(30) Priority: 29.11.1988 US 277637; 29.11.1988 US 278333; 29.11.1988 US 277687
(43) Date of publication of application: 25.01.1995
(62) Divisional of application: 89122020.4
(73) Proprietor: MATSUSHITA ELECTRIC INDUSTRIAL CO., LTD., Kadoma-shi, Osaka 571 (JP)
(72) Inventor: Harlin, Roy Edward, Fort Collins, Colorado 80525 (US); Herrington, Richard Arthur, Fort Collins, Colorado 80525 (US)
(74) Representative: Schwabe - Sandmair - Marx

(56) References cited:
- EP-A- 0 197 413
- GB-A- 2 198 266
- US-A- 4 663 735

## Description

The invention relates to a dynamic random access memory integrated circuit and a method for accessing such a circuit.

With the cost per bit of a semiconductor memory and the price of computer systems dropping, personal work stations and other computer systems using graphics such as CAD/CAM systems are becoming more readily availabe. A crucial component in such systems is the dynamic video RAM which supports the graphics applications.

Conventional dynamic video RAMs, available on multichips, have a random port and a serial port enabling a computer to access the dynamic video RAM through the random port and enabling the serial port to deliver the necessary graphics information to drive, for example, a color monitor.

In designing dynamic video RAMs, several features are of critical importance.

First, it is important to package the (video) RAM on a single integrated circuit chip minimizing the number of external pins from the chip. Secondly, it is important to maximize the memory contained on the chip. Third, it is important to perform as many of the modification operations on chip to increase the speed, rather than having off chip hardware perform these operations at a much slower rate off the chip. Fourth, it is important to maximize the addressing capabilities of the data stored within the chip. The number of clock inputs controlling the random port of the video RAM leads to complexity and slower speed.

The following patents are representative of issued patents involving dynamic RAMs commercially available. In each of these patents, no provision is made for incorporating both the conventional image mode addressing and the vector mode addressing of the present invention onto the chip carrying the RAM. The conventional image mode addressing is slow when a vertical line in the screen is to be modified. Each scan line in memory must be addressed even though each scan line contains only one pixel in the vertical line to be modified. Hence, a substantial number of scan lines in memory must be addressed to modify the line. Under the teachings of the present invention, the vertical line can be addressed as a vertical vector in a page and, therefore, only those vertical vectors comprising the vertical line need to be addressed. This substantially speeds up the addressing for vertical lines in the dynamic video RAM.

In each of these patents, further, no provision is made for incorporating the drawing or replacement rules onto the chip carrying the RAM. Rather, in order to modify a given line of information stored in the RAM, the information to be modified must be read out from the dynamic video RAM and modified off chip according to the acquired logical operation. The present invention performs the drawing or replacement rule with circuitry located on the chip and further is able to selectively mask the areas of modified information to be read back into the RAM.

US-A-4,688,197 sets forth a video computer system having a RAM chip with a shift register connected to its serial output terminal which is actuated by a first clock and a second clock is utilized to load the serial chip register.

US-A-4,689,741 pertains to the same invention as the Novak patent but provides for coupling of data between column lines and the chip register to prevent two or more different data bits from simultaneously appearing.

US-A-4, 565, 495 sets forth a single chip dynamic RAM controller and CRT controller system arrangement. This invention minimizes the control circuit of prior systems thus eliminating potential bottle necks at the RAM by utilizing a single controller. A related U.S. patent also issued to Thaden et al. is US? 4,656,596. The RAM of Thaden resides on a chip separated from the controller chip and the control signals are sent to the RAM.

US-A-4,546,451 sets forth a dynamic RAM which permits "page mode" addressing horizontal or vertical vector addressing. While Bruce shows a graphics controller device (GDC) clock, this clock is delivered from the RAM chip to the separate GDC. More importantly, the separate GDC must provide the load, count enable and other control signals directly to the RAM chip.

US-A-4,646,270 sets forth a video graphic dynamic RAM having the capability of serially reading out data at a high rate of speed while performing standard RAM operations.

A need exists for a dynamic video RAM which performs both vector mode addressing (i.e., horizontal and vertical vectors) and image mode addressing on a single chip containing high capacity memory, contains the necessary hardware to perform on-chip modification of the stored video information, and accomplishes this with a minimum number of external pins.

There is no disclosure in any one of the above patents of circuitry to perform drawing rule modification on chip with the random access memory.

In the target specification of the Hitachi HM53462 Multi Port DRAM, logic operation and masking occur on a single chip. However, in this approach the system must first deliver the logic operation to the chip and then cycle to address the memory, deliver the new source data, read from memory and then modify the read information.

A need exists not only for providing the drawing rule and masking circuitry on the chip with the RAM but also to maximize the performance by delivering the drawing rule with the addresses to the chip at the same time.

EP-A-O 197 413 shows that locations in a RAM sharing a common row address but with different column addresses are sequentially accessed. Thus the modification of a vertical or horizontal line requires addressing the locations of the RAM for a plurality of times.

Supplementarily, US-A-4 442 503, US-A-3 996 559 and WO-A-84 03970 shows RAM devices which are comparable with this according to EP-A-O 197 413.

In the above patents, no provision is made for utilizing a single clock on the random port side of the RAM to control the operation of the RAM including the loading of information into the address and data registers, the operation of the RAM and the modification of the information in the RAM.

It is the object of the present invention to accelerate memory access of dynamic random access memories.

This object is solved by the subject matters of the independent claims.

The invention concerns a dynamic random access memory integrated circuit comprising:
a) a memory block including a plurality of memory cells for storing information,
b) an input for receiving an external clock signal, and
c) address input means for receiving a first address and a second address defining a location of information stored in said memory block.

According to the invention said dynamic random access memory integrated circuit is a synchronous circuit, wherein
d) said address input means provides said first address as an output in response to a first edge of said external clock signal, said address input means provides said second address as an output in response to a second edge of said external clock signal,
e) access means are provided for accessing a location in said memory block corresponding to said first address and said second address provided by said address input means, and wherein
f) control means are provided for outputting internal control signals defining timings of internal operations of said dynamic random access memory in response to an external control input on an edge of said external clock signal, wherein a logic level of each of said internal control signals is determined concurrently in response to the same edge of said external clock signal.

The invention also concerns a method for accessing a dynamic random access memory integrated circuit including a memory block having a plurality of memory cells for storing information, address input means for receiving a first address and a second address defining a location of information stored in said memory block, access means for accessing said memory block and an input for receiving an external clock signal.

According to the invention said dynamic random access memory integrated circuit is a synchronous circuit and the method comprises the steps of:
a) providing said first address as an output of said address input means in response to a first edge of said external clock signal,
b) providing said second address as an output of said address input means in response to a second edge of said external clock signal,
c) accessing a location in said memory block corresponding to said first address and said second address provided by said address input means, and
d) outputting internal control signals defining timings of internal operations of said dynamic random access memory in response to an external control input on an edge of said external clock signal using a control means, wherein a logic level of each of said internal control signals is determined concurrently in response to the same edge of said external clock signal.

Said first edge of said external clock signal is preferably different from said second edge of said external clock signal.

Preferred embodiments of the invention are disclosed by the dependent claims.

Said control means preferably comprises means for determining a next state in response to a current state and said external control input on an edge of said external clock signal, and means for producing said internal control signals as a function of said next state, said internal control signals beeing in particular a first enable signal and a second enable signal for said address input means and an output enable signal for an output means for outputting information stored at said location of said memory block.

The particular dynamic random access memory integrated circuit according to the invention in particular for video purposes may have an architecture for addressing vectors in a dynamic video random access memory placed on an integrated circuit chip, said dynamic video random access memory being connected to a bus (90, 100), said architecture on said integrated circuit chip comprises a memory (1300) for storing video information, said memory having a plurality of "n" x "m" bit of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, address means (1360) connected to said bus for receiving the address of a horizontal or vertical vector in a page of said memory to be modified, said address comprising: (a) a first plurality of bits for defining the page row of said addressed page, (b) a second plurality of bits for defining the page column of said addressed page, and (c) a third plurality of bits for defining the addressed vector in said addressed page, data means (1340) connected to said bus for receiving source data, and control means (1366, 1360, 1354, 1336) connected to said memory, said address means, and said data means for modifying the stored video information with said source data at the addressed vector in said memory.

The dynamic random access memory integrated circuit of this invention, which is also applicable for video purposes is connected to a bus (90, 100), and
preferably comprises an integrated circuit chip, a memory (1300) on said chip for storing video information, said memory having a plurality of "n" x "m" bit pages (PG), each said page containing a plurality of horizontal and vertical vectors, address means (1360) on said chip and connected to said bus for receiving the address of a horizontal or vertical vector in said page of said memory, said address comprises (a) a first plurality of bits for defining the addressed page, and (b) a second plurality of bits for defining the addressed horizontal or vertical vector in said addressed page, data means (1340) on said chip and connected to said bus for receiving source data, and control means (1366, 1360, 1354, 1336) on said chip and connected to said memory, said address means, and said data means for modifying the stored (video) information with said source data at the addressed vector location in said memory.

The dynmaic random access memory integrated circuit of this invention can also be provided with an architecture for addressing in either the image and vector modes, and is connected to a bus (90, 100), said architecture comprises a memory (1300) for storing video information, said memory being addressed with either vector and image addresses, said memory: (a) in said vector address mode, having a plurality of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, (b) in said image address mode, having a plurality of scan lines, each of said scan lines containing a plurality of words, address means (1360) connected to said bus for receiving the address mode (V/I), and either the vector mode address for a horizontal or vertical vector to be modified in said memory or the image mode address of a word to be modified in said memory, said vector mode address comprises (a) a first plurality of bits for defining the page row of said addressed page, (b) a seccnd plurality of bits for defining the page column of said addressed page, and (c) a third plurality of bits for defining the addressed vector in said addressed page, said image mode address comprises (a) a first plurality of bits for defining the scan line being addressed, and (b) a second plurality of bits for defining the addressed word in said addressed scan line, date means (1340) connected to said bus for receiving the source data for modifying the stored (video) information at said vector or image addresses, and control means (1366, 1360, 1354, 1336) connected to said memory, said address means, end said data means for modifying the stored video information with said source data at the image mode or vector mode addresses.

In a preferred embodiment the dynamic random access memory integrated circuit of this invention is placed on a single integrated circuit chip and connected to a bus (90, 100), and comprises means for storing video information in a memory located on said chip having a plurality of pages (PG), each of said pages having defined page column (PC) and page row (PR) locations in said memory, each said page containing a plurality of horizontal (610) and vertical (600) vectors, each said horizontal vector being defined by a vector row location in said page and each said vertical vector being defined by a vector column in said page, means for receiving on said chip the address of a vector in a page of said memory to be modified over said bus, said address comprises (a) a first plurality of bits for defining the page row of said addressed page, (b) a second plurality of bits for defining the page column of said addressed page, and (c) a third plurality of bits for defining the addressed vector in said addressed page, means for receiving on said chip the source data over said bus for modifying the stored video information at said addressed vector in said addressed page, and means for modifying on said chip the stored information or video information with said source data at the addressed vector location in said memory.

The dynamic random access memory integrated circuit of this invention can be connected to a random bus and to a serial bus, and comprises preferably a single integrated circuit chip (10) connected to said serial and random buses, a memory (1300) on said chip for storing video information, said memory being addressed in serial data transfer, vector, and image modes of operation, said memory: (a) in said vector address mode, having a plurality of pages (PG), each said page containing a plurality of horizontal (610) and vertical (600) vectors, (b) in said image address mode, having a plurality of scan lines, each of said scan lines containing a plurality of scan words, (c) in said serial data transfer mode, having a plurality of partial scan lines, each of said partial scan lines containing a plurality of partial scan words, address means (1360) on said chip and connected to said random bus for receiving the mode of operation and (1) the vector mode address for a vector in said memory, (2) the image mode address for a scan line in said memory, and (3) the serial data transfer address for the partial scan line in said memory, random port control means (1366, 1360, 1354, 1336, 1340) connected to said memory and said address means fcr accessing information at the memory locations of the image mode or vector mode addresses, said random control means reading said memory at said serial data transfer addresses, and serial pcrt control means (1304, 1306, 1314) connected to said memory for delivering said read information at said serial data transfer address to said serial bus.

The dynamic random access memory integrated circuit of this invention, also for video purposes, has an architecture, placed preferably on an integrated circuit chip, and connected to a bus (90, 100, 140); said architecture on said integrated circuit chip comprises a memory (1300) for storing information, address means (1360) connected to said bus for receiving the address of vector data to be modified in said memory, data means (1340) connected to said bus for receiving drawing rule data and source data, said drawing rule data designating the logical operation for modifying said vector data of stored information and said source data being used to perform said modification, said data means further receiving the START and STOP location data which are the beginning and ending bit locations in said vector data, drawing rule means (1354, 1360) connected to memory for obtaining said vector data to be stored and connected to said data means for obtaining said drawing rule data, said drawing rule means logically combining said vector data of stored information and said source data according to said drawing rule logical operation to modify said vector data to be stored, write mask means (1336) connected to said data means for obtaining said START and STOP locations and connected to said memory for allowing said writing of said logical combination into said memory only between said START and STOP bit locations of said vector data, and control means (1366) connected to said drawing rule means and said memory for activating said drawing rule means to perform said logical combination, and said control means finally writing said modified vector data of information resulting from said logical combination into memory only between said START and STOP bit locations.

The dynamic random access memory integrated circuit of this invention is preferably placed on an integrated circuit chip, and connected to a bus (90, 100, 140); said dynamic random access memory has an architecture on said integrated circuit chip comprises a memory (1300) for storing information, address means (1360) connected to an address bus for receiving during a first time interval the address of vector data of said stored information in said memory to be modified, data means (1340) connected to a data bus for receiving during said first time interval the drawing rule data, said drawing rule data designating the logical operation for modifying said vector data, drawing rule means (1354, 1360) connected to said memory for obtaining said vector data of information to be stored and connected to said data means for obtaining said drawing rule, said drawing rule means logically combining during a second time interval said vector data of stored information and said source data according to said drawing rule logical operation, control means (1366) connected to said memory, address means, data means and drawing rule means for activating during said second time interval said drawing rule means for performing said logical combination, said control means writing during a third time interval said logically combined information into

The dynamic random access memory integrated circuit of this invention, which can also be used in connection with video applications, is preferably placed on a single integrated circuit chip, and connected to a bus (90, 100, 140), comprises means for receiving on the chip from the bus and during a first time interval: (a) the address of vector data to be modified stored in the memory, (b) the drawing rule data containing the logical operation for modifying the stored vector data, (c) the START and STOP locations for modifying the vector data between identified beginning and ending bit locations, means for receiving on the chip from the bus and during a second time interval following the first time interval source data to be logically combined with the addressed vector data, means for modifying on the chip and during a third time interval following the second time interval the addressed vector data with the source data based upon the logical operation of the received drawing rule data, and means for writing the memory during a fourth time interval following the third time interval between the START and STOP bit locations with the modified vector data of information.

The dynamic random access memory integrated circuit of this invention has a random port (1200), connected to a bus (90, 100, 140), said bus carrying a single clock, said improved random port comprises address means (1330, 1360) connected to said bus for receiving the address of stored information in said memory, source means (1340) connected to said bus for receiving source data, output means (1338) connected to said memory for delivering said addressed stored information from said memory to said bus, modification means (1336, 1354 and 1360) connected to said memory for obtaining said addressed stored information and connected to said source means for obtaining said source data, said modification means combining said addressed stored information with said source data to modify said stored information and to write said modified information back into said memory, and control means (1366) connected to said bus and to said address means, said source means, said output means, said modification means, and said memory; said control means being responsive to the receipt of said single clock from said bus for controlling the operation of said address means, said source means, said output means, said modification means, and said memory.

The dynamic random access memory integrated circuit of this invention is connected to a random port bus (90, 100, 140) and to a serial port bus (50, 70), said memory comprises said random port bus carrying addresses, data, random port control enables, and a single random port clock signal, said serial port bus carrying serial data, serial port control enables, and a single serial port clock signal, preferably a single integrated circuit chip connected to said serial and random port buses, a memory (1300) on said chip for storing information, random port means (1200) on said chip and operative with said single random port clock signal and receptive of said random port control enables from said random port bus for receiving from said addresses, said addresses being (1) the random access addresses for said memory and (2) the serial data transfer addresses for said memory, said random port means being connected to said memory for accessing information at the memory locations of said received random access addresses, said random port means reading information from said memory at said received serial data transfer addresses, and serial port means (1210) on said chip and operative with said single serial port clock signal and receptive of said serial port control enables for delivering said read information from said memory at said serial data transfer address to said serial port bus.

The dynamic random access memory integrated circuit of this invention is preferably placed on a single integrated circuit clip and includes a random port, said random port interfaces said dynamic random access memory with a random port bus (90, 100, 140), said memory further includes a control means which comprises means for receiving one set of a plurality of sets of control signals from the random port bus, each set of said plurality of sets corresponding to a different mode of operation for said random port, means for configuring a predetermined sequence of internal control enable pulses for controlling the operation of the random port corresponding to one set of said control signals received, means for receiving a single clock signal having a preselected frequency over the random port bus, and means for executing the configured predetermined sequence of internal enable pulses with the clock pulses of the received single clock so that the random port operates in the mode of operation corresponding to the received set of control signals.

The present invention, in a preferred embodiment, is a 1,310,720 bit dual ported, dynamic memory having random and serial ports. There is well over one million bits of stored information stored in the memory. The random port supports the two modes of access: a vector access to a 32 by 32 bit page and an image access to a 16 by 1 word. The serial port consists of eight, thirty-two bit dynamic latches providing 256 consecutive bits for a screen refresh. The dynamic video RAM of the present invention incorporates built-in drawing rule cycles, a clocked random port for synchronous operation, optimized vector operation and sixteen bit read and write access.

In the preferred embodiment, the RAM or video RAM is packaged on a chip where the random port is accessed by an eleven pin address, a sixteen pin data path, chip select, vector/image select, read/write signal and random port clock. The serial port is supported by the serial clock, serial output enable, load signal and four serial output data lines. The chip is powered by at least two Vcc and two Vss lines. While the preferred invention has at least forty-four pins on this chip, more pins could be added.

In the vector mode of operation, the dynamic RAM or the dynamic video RAM of the present invention writes both horizontal and vertical vectors to a thirty-two by thirty-two bit page. The cells within a page in the preferred embodiment are addressed as a thirty-two bit vertical or horizontal vector column or row. However, the calls could be any desired selection such as "n" x "m". The address selects the page location of the vector and the row-column of the vector within the page. The data lines carry START and STOP locations within the page and the horizontal/vertical orientation of the vector within the cell. The drawing rule of the vector is also carried on the data lines with a source of the vector always defaulting to one. Once selected, a vector page can be accessed as a series of page mode cycles specifying column or row and START and STOP locations. In the preferred embodiment, vectors are write only.

Under the image mode of operation, the RAM or dynamic video RAM of the present invention allows the random access memory port array to be written and read directly. On writes, the address input of the address lines selects a thirty-two by thirty-two bit page, the page identical to that selected in vector mode. The row within the page is identical to the vector row selected while in the vector mode. The word is masked according to the START and STOP locations specified in the first data mode of the cycle. This first data word also carries the drawing rule specification. The second data word of the cycle carries the sixteen bit word image word. Reads are also sixteen bits wide and the address is specified in the write cycle, with the addition of the least significant address to control whether the least or the most significant word in the row is placed on the sixteen bit data bus. The START, STOP, and drawing rule have no effect on read cycles. Page mode works for both reads and writes, allowing the full thirty-two by thirty-two page to be accessed in one page cycle. The present invention provides a conventional internal refresh to the memory.

Finally, transferring data to the shift register is accomplished by executing a cycle with the vector/image line asserted to vector and the read/write line asserted to read. This places the contents of 256 cells in a dynamic latch ready to be loaded into the serial port register. While only 256 cells are written to an internal latch, the full 8,192 cells are accessed and refreshed during the serial data transfer. The 256 bits transferred during the transfer are referred to as a partial scan line and replacement rules have no effect on serial data transfer.

All of the above random port operations (i.e., not the transfer through the serial port) are accomplished through the use of a single clock pulse delivered to a random state machine and in conjunction with the enable levels of the V/I (vector-image), R/W (read-write), refresh, and the CS (chip-select) control lines.

Thus, the invention described herein makes possible the objectives of:
(1) providing a dynamic RAM or dynamic video random access memory in which the addressing for vertical lines is speeded up;
(2) providing a dynamic RAM or a dynamic video random access memory in which a vertical line can be addressed as a vertical vector in a page and, therefore, only those vertical vectors comprising the vertical line need to be addressed;
(3) providing a DRAM or video DRAM which can perform both vector mode addressing (horizontal and vertical vectors) and image mode addressing on a single chip containing high capacity memory;
(4) providing a DRAM or video DRAM which contains the necessary hardware to perform on-chip modification of the stored video information;
(5) providing a DRAM or a dynamic video random access memory which has a minimum number of external pins;
(6) providing a DRAM or a dynamic video random access memory which has a circuitry to perform drawing rule modification on a chip with the random access memory;
(7) providing a DRAM or a dynamic video random access memory which can provide the drawing rule and masking circuitry on a chip with the random access memory and maximize the performance by delivering the drawing rule with the address to the chip at the same time;
(8) providing a dynamic random access memory which can utilize a single clock on the random port side of the memory to control the operation of the memory including the loading of information into the address and data registers, the operation of the memory and the modification of the information in the memory; and
(9) providing a dynamic random access memory which can minimize the number of signal paths to and from the chip while providing for a faster operation.

This invention may be better understood and its numerous objects and advantages will become apparent to those skilled in the art by reference to the accompanying drawings as follows:

Figure 1 is a block diagram of a system incorporating the DRAM or dynamic video RAM of the present invention.

Figure 2 illustrates the screen of the color monitor 20 of the system of Figure 1 and a partial scan line.

Figure 3 illustrates the serial data transfer address of the present invention.

Figure 4 illustrates the most significant address and least significant address of the serial data transfer address of Figure 3.

Figure 5 sets forth the page layout of the screen of the color monitor 20 of the present invention.

Figure 6 shows vectors within an individual page.

Figure 7 is the format for a page address.

Figure 8 shows the most significant address and least significant address bits of the page address of Figure 7.

Figure 9 shows the image mode addressing scheme of the color monitor of the present invention.

Figure 10 shows the format of the image address.

Figure 11 shows the most significant and least significant address portions of the image address of Figure 10.

Figure 12 illustrates the structure of a single chip of the dynamic video RAM of the present invention.

Figure 13 sets forth the circuit block diagram of the dynamic video RAM chip of the present invention.

Figure 14 sets forth the format of the data inputs for the image mode of operation.

Figure 15 sets forth the format for the data inputs for the vector mode of operation.

Figure 16 is an illustration of a vector mode operation.

Figure 17 is an illustration of an image mode operation.

Figure 18 shows the timing for serial data transfer.

Figure 19 shows the timing for vector write.

Figure 20 shows the timing for vector write, page mode.

Figure 21 shows the timing for image read/write.

Figure 22 shows the timing for image read/write, page mode.

Figure 23 shows the timing for image read modify write.

Figure 24 sets forth an implementation of a random port state machine.

### DESCRIPTION OF THE PREFERRED EMBODIMENTS

### 1. General Description

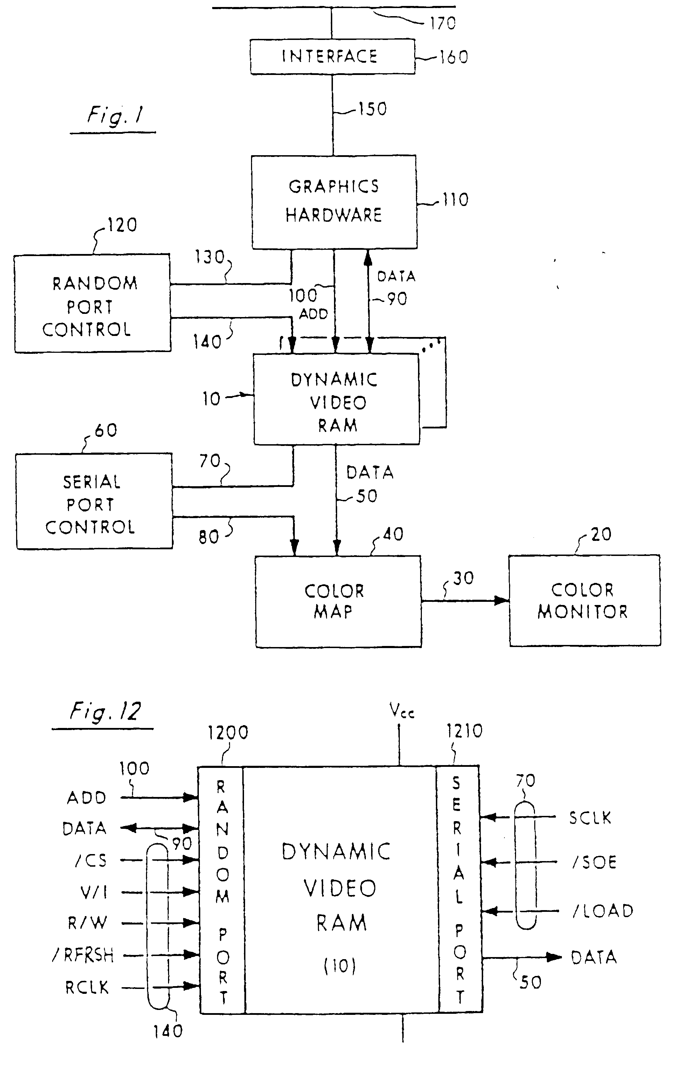

Figure 1 sets forth the dynamic video RAM 10 of the present invention in a system environment having a color monitor 20 interconnected over lines 30 with a color map circuit 40. The color map circuit 40 is in turn connected over video data bus 50 to the dynamic video RAM 10 of the present invention. Both the dynamic video RAM 10 and the color map 40 are under control of a serial port control 60 over lines 70 and 80. The dynamic video RAM 10 is also interconnected over a data bus 90 and an address bus 100 to a graphics hardware circuit 110. A random port controller 120 controls the graphic hardware circuit 110 over lines 130 and the dynamic video RAM 10 over lines 140. The graphics hardware circuit 110 is interconnected over lines 150 to an interface circuit 160 which communicates with a standard bus 170.

The dynamic video RAM 10 of the present invention stores the image which is actually being displayed on the color monitor 20. The stored information in the video RAM 10 is delivered over the data bus 50, sequentially, to the color map circuit 40 for display on the monitor 20. The serial port control 60 controls the transfer of the stored information in the dynamic video RAM 10 to the color map 40.

When it is desired to change the stored information in the dynamic video RAM 10 in order to change the displayed image on the color monitor 20, appropriate commands come over bus 170 such as from a CPU or the like, not shown, and is received by the interface circuit 160 for delivery into the graphics hardware circuit 110. The random port control 120 controls the changing of the information stored in the dynamic video RAM based upon the information received by the graphics hardware from bus 150. The address for the information to be changed is delivered over address bus 100 and the data for the change is delivered over data bus 90. In this fashion, the dynamic video RAM information can be modified to change the image on the color monitor 20.

It is to be expressly understood that the system environment shown in Figure 1 is for purposes of illustration only and that the dynamic video RAM of the present invention could be utilized in other environments. For example, a color map and color monitor may not be present.

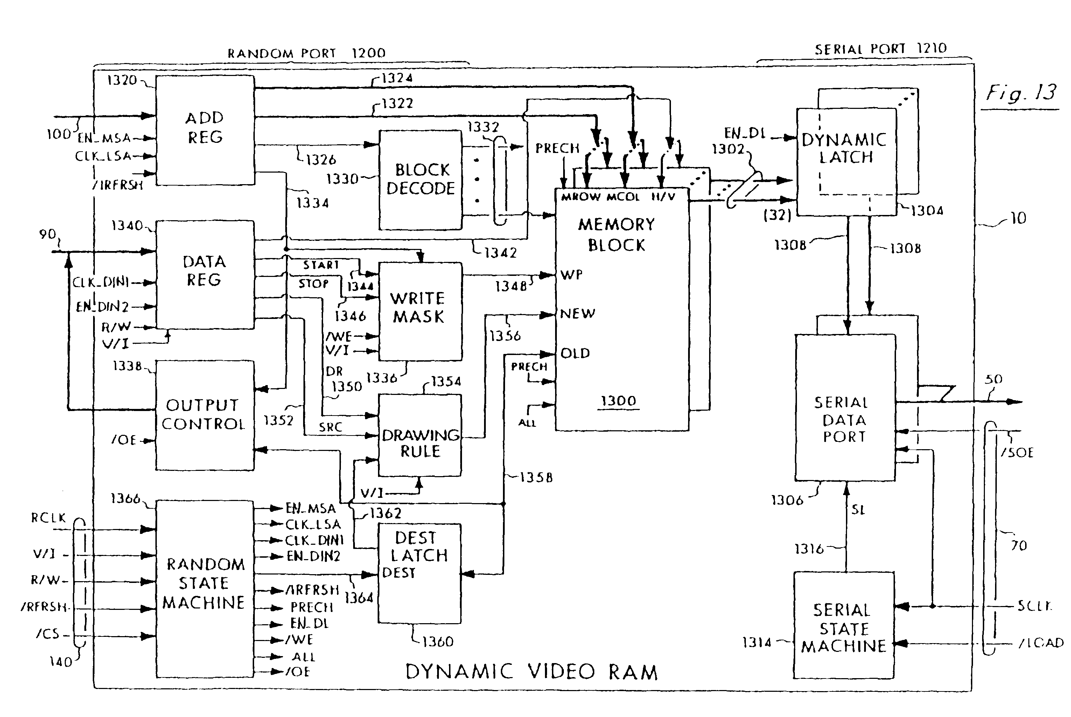

In the preferred embodiment of a single chip as shown in Figure 12, the random port bus comprises an address bus 100 which is eleven bits wide, a data bus 90 which is sixteen bits wide and a control bus 140 which is five bits wide. The serial port bus comprises a data bus 50 which is four bits wide and a control bus 70 which is three bits wide. Hence, the dynamic video RAM 10 has thirty-nine pins plus four pins for power and ground for a total of forty-four. The present invention as set forth next, however, is not limited to a configuration having this number of pins. As shown in Figure 1, a number of these single chips can be utilized in a system environment. The /CS control enable carried by control bus 140 selects which chip is accessed.

Three modes of addressing and operating the dynamic video RAM 10 over address bus 100 are present. They are (a) the serial data transfer mode, (b) the vector address mode, and (c) the image address mode. Each mode will be discussed in the following.

### a. Serial Data Transfer Mode

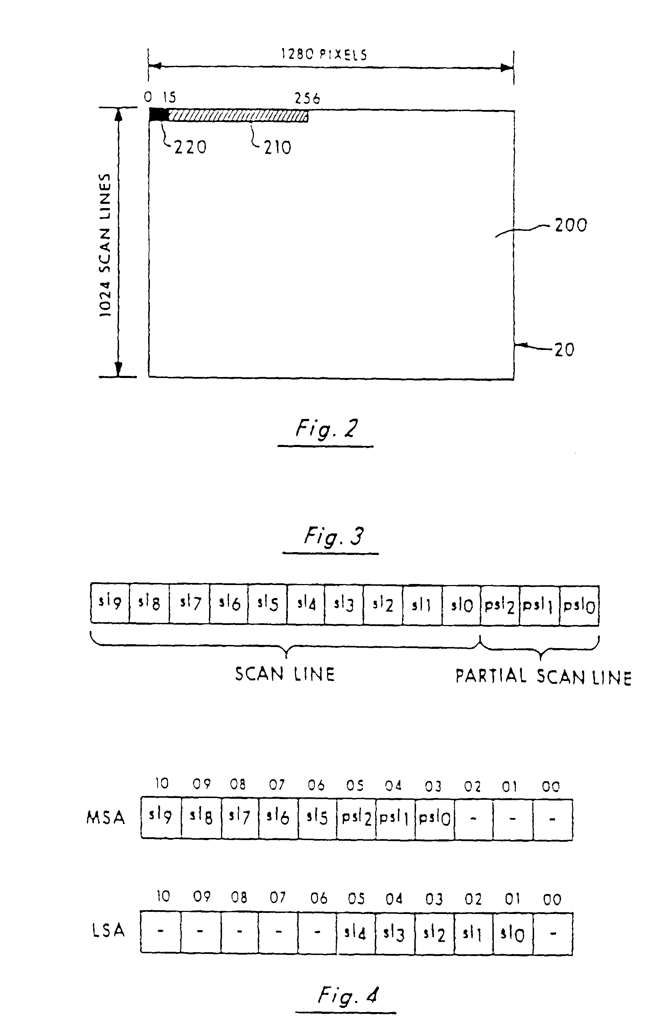

In Figure 2, the screen 200 of monitor 20 is shown. Screen 200 is conventional and may have, for example, 1280 pixels across the screen in a horizontal line with 1024 scan or raster lines in the vertical direction. It is to be expressly understood that any configuration of pixels and scan lines could be used under the teachings of the present invention. In Figure 2, a partial scan line 210 is also shown. A "partial scan line" is defined herein to be 256 contiguous pixels in a scan line. A "word" is defined to be 16 pixels. Hence, a partial scan line contains 16 words. This corresponds to conventional image mode addressing found in other video RAM devices.

The dynamic video RAM 10 of the present invention is capable of being addressed over random port address bus 100 to perform serial port data transfers over data bus 50 under the serial port control 60. In Figure 3, the serial data transfer address is shown. The 1024 scan lines are selected by the ten bit scan line field and the partial scan lines 210 are selected by the three bit partial scan line field. A total of thirteen bits are required to perform serial data transfer addressing. Since address bus 100 is only eleven bits wide, two addresses are delivered as shown in Figure 4. The first transfer being the most significant address (MSA) and the second transfer being the least significant address (LSA). Again, it is to be expressly understood that the present invention is not limited to this number of bits or to this configuration of addressing.

Figures 2-4, therefore, show the addressing of the dynamic video RAM 10 of the present invention in the serial data transfer mode.

### b. Vector Addressing Mode

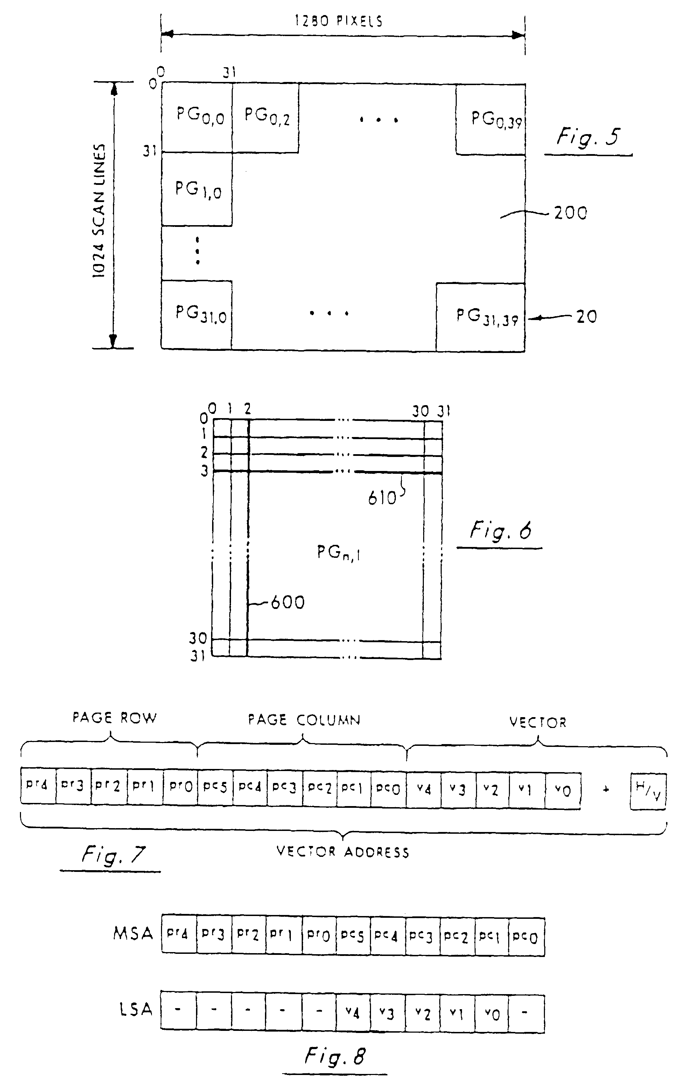

The present invention provides a mode of vector addressing wherein a page can be accessed either horizontally or vertically on the screen. This is shown in Figures 5-8.

A page is defined to be a 32 by 32 array of pixels. In Figure 5, the page PG (0,0) has 32 horizontal scan lines by 32 horizontal pixels. It is to be expressly understood that a page could be of any similar "m" x "n" configuration. The screen monitor of Figure 5 has 32 times 40 or 1280 pages. The term "page column" is defined to be the horizontal location of a page and the term "page row" is the vertical location of a page. For example, for page PG (31,39), the page column is 39 and the page row is 31. The page row in the preferred embodiment of 32 rows can be addressed by a 5 bit word. For example, the page row value for page PG (31,0) is 11111. Likewise, the 40 page columns, in the preferred invention of 1280 pixels can be addressed by a six bit word.

Figure 6 shows an individual page PG (n,i). The term "vector column" identifies the horizontal location of a vector within a page. For example, vector 600 is located in vertical row 2. The term "vector row" is defined to mean the vertical location at a vector within a page. For example, vector 610 is located in column 3. In the vector mode addressing scheme of the present invention, one bit, the H/V bit is used to define whether the vector is horizontal 610 or vertical 600. Five bits are then utilized to locate the vector within the page. For example, for the vector 610, the H/V bit equals 1 to designate a horizontal vector and the remaining 5 bits are 00011. The vertical vector 600 has the H/V bit set to 0 and the remaining 5 bits are 00010.

The vector addressing scheme shown in Figures 5 and 6 is unique to the present invention and permits not only a select page PG to be addressed but also to address a vertical or horizontal vector within the page.

Therefore, the necessary page address, as shown in Figure 7 and in the preferred embodiment, is a 16 bit word having 5 bits to identify the page row, 6 bits to identify the page column, and 5 bits to identify the vector. The additional horizontal/vertical (H/V) bit identifies whether the vector is horizontal or vertical within the page. In this fashion, a specific vector such as either vector 600 or 610 in Figure 6 in a selected page on the screen 200 can be addressed.

Since, the address bus 100 in Figure 1 is 11 bits wide, the graphics hardware 110 outputs the vector address of Figure 7 as two separate transfers. The first transfer being the most significant address (MSA) and the second address being the least significant address (LSA) both shown in Figure 8.

It is to be expressly understood that Figures 5 through 8 set forth one approach under the teachings of the present invention and that other bit layouts and address configurations could be used to accomplish the vector mode of addressing.

### c. Image Address Mode

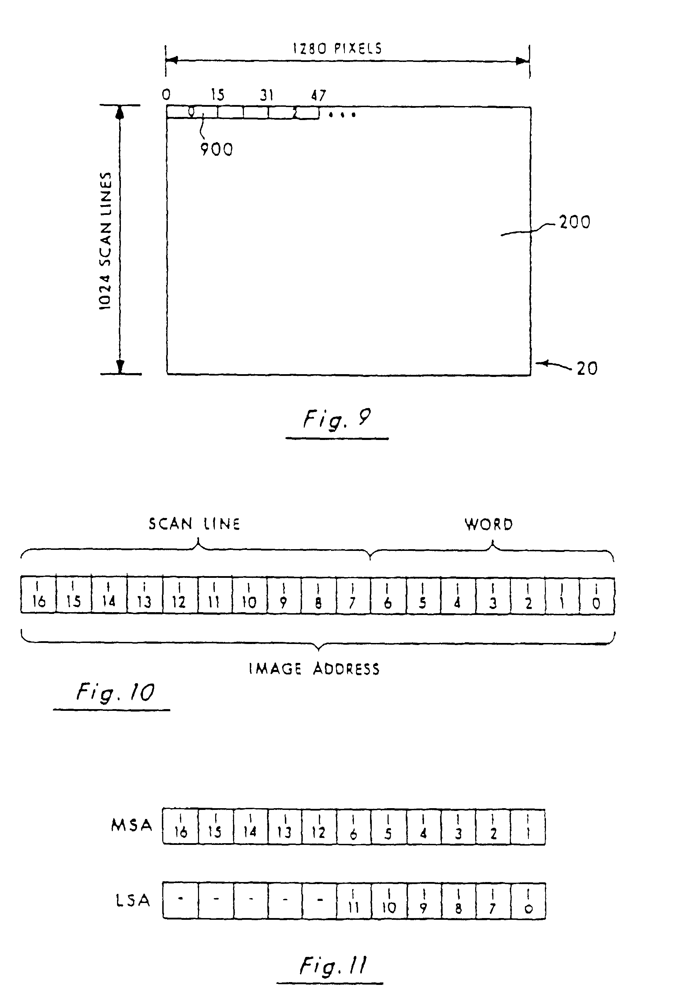

The present invention is also capable of image mode addressing as shown in Figures 9-11. To locate a scan line on screen 200, would require 10 bits in the example shown of 1024 scan liner. A scan line is defined as the set of contiguous pixels making up a complete scan line on a raster scan display. There are eighty 16 bit words in a scan line. Therefore, seven bits are required to lodate a word in a given scan line. Hence, the image address as shown in Figure 10 has 10 bits to identify the scan line and 7 bits to identify a word within the scan line. Because of the structure of the video RAM of the present invention, the address bus 100 as shown in Figure 1 is limited to 11 bits and, therefore, as shown in Figure 11, the image address is transferred in an MSA cycle and an LSA cycle.

As discussed above, three modes of addressing occur on address bus 100. These three modes are serial data transfer (Figures 2-4), vector mode addressing (Figures 5-8) and image mode addressing (Figures 9-11) and cause the video RAM 10 of the present invention to operate in these different modes. The serial data transfer mode effectuates transfer of information from the RAM 10 over data bus 50. The vector and image modes permit changes to be made to the information stored within the RAM 10.

### d. Chip Configuration

In Figure 12, the dynamic video RAM 10 of the present invention is shown as a discrete single integrated circuit chip. With reference back to Figure 1, the random port side 1200 of the RAM 10 has the following pin designations:
1. Address Bus 100 (11 pins)
2. Data Bus 90 (16 pins)
3. /CS-chip select
4. V/I - Vector/Image Select
5. R/W - Read/Write Select
6. RFRSH - Refresh
7. RCLK - Random Port Clock

On the serial port side 1210 of the dynamic video RAM 10 the following pins are designated:
1. SCLK - Serial Clock
2. /SOE - Serial Output Enable
3. /LOAD - Load Signal
4. Data Bus (4 pins)

In addition, two voltage, Vcc, pins and two ground pins, Vss, are required.

The chip select signal (/CS) selects which chip is being selected. For example, in Figure 1, any number of chips 10 can be positioned within the system environment. If, for example, sixteen chips are required, then the appropriate /CS pin would be activated by the random port control 120.

As previously discussed, the vector-image signal (V/I) determined whether the chip is being addressed in the vector or image modes. In the preferred embodiment, when V/I is high, the chip is in the vector mode and when the V/I signal is low, the chip executes in the image mode.

The read/write signal (R/W) performs as follows. When R/W is high, the chip 10 is in the read mode and data appears on data bus 90. When R/W is low, the chip is in the write mode and the data is written into the memory found within chip 10. The following modes of operation occur within the chip 10:

**TABLE I**

| V/I | R/W | Cycle |
|---|---|---|
| 0 | 0 | image write |
| 0 | 1 | image read |
| 1 | 0 | vector write |
| 1 | 1 | serial data transfer |

The random port clock (RCLK) is a single clock signal delivered to the chip 10. All internal random port operations of the chip 10 are synchronized with and derived from this clock signal. This is the only clock signal to the random port and is preferably one megahertz.

The address signals on random port address bus 100 carries the bit addresses for the MSA and LSA addresses as shown in Figure 4 for serial data transfer, in Figure 8 for vector mode addressing, and in Figure 11 for image mode addressing.

The data appearing on random port data bus 90 is sixteen parallel bits and is delivered into the chip 10 as two sets of data - DIN1 and DIN2. This is shown in the following table:

**TABLE II**

| Mode | DIN1 | DIN2 |
|---|---|---|
| Vector | DR, START/STOP, H/V | - |
| Image | DR, START/STOP | Read or Write |
| (Where DR = Drawing Rule, H/V = Horizontal/Vertical) | | |

Also delivered to the RAM 10 of the present invention from the random port control 120 is a /RFRSH which is used as an internal refresh signal.

The RAM 10 of the present invention also receives control signals from the serial port control 60 over serial port control bus 70. The SCLK signal is a single serial port clock, the /SOE is a serial output enable signal. When /SOE is low, serial read data appears on the data bus 50. The /LOAD is a data load signal. The present invention only uses a single clock on the serial port 1210 to transfer data to the serial port.

The two Vcc pins shown in Figure 12 provide power which in the preferred embodiment is plus five volts and the Vss pins are the two ground pins. More or less than two pins for power and ground can be used under the teachings of the present invention.

The single integrated chip shown in Figure 12 contains in the random port 1200 and in the serial port 1210 all of the necessary circuitry to operate the RAM in the three modes of operation (Serial data transfer, Vector addressing and Image Addressing). The random port is controlled through receipt of one of a plurality of sets of control enables over bus 140 which configure the RAM to operate in its various modes of operation. The delivery of the single clock RCLK then is used to produce the necessary internal control enables to execute the selected mode of operation.

The signals appearing on the pins shown in Figure 12 will now be discussed in the following detailed description of the internal configuration and operation of the dynamic video RAM 10 of the present invention. It is to be expressly understood that the pin number and selection represents only a preferred embodiment and that other embodiments may be designed within the teachings of the present invention.

### 2. Detailed Description

This section discusses the detailed structural embodiment of the dynamic video RAM chip 10 of the present invention and the preferred operation. The individual register, latch, shift, and other disclosed circuits are individually conventional in operation and design. The combined circuit layout, however, is unique and while one preferred layout is shown, it is to be expressly understood that other layouts based upon the teachings of this invention could be used.

### a. Serial Port Side 1210 Configuration

The components of the dynamic video RAM 10 of the present invention are set forth in Figure 13 to include a plurality of memory blocks 1300. Each memory block 1300 is, in the preferred embodiment, 160 memory cells by 1024 memory cells. There are 8 memory blocks for a total of 1,310,720 cells on a single chip although it is to be expressly understood that any number could be used.

The output from the memory block 1300 is delivered over lines 1302 into a plurality of dynamic latches 1304. Each dynamic latch 1304 stores 32 bits of information as read from its respective interconnected memory block 1300. The eight latches, therefore, hold 256 bits or a partial scan line. The output of each dynamic latch 1304 is delivered to a respective serial data port register 1306 over interconnecting lines 1308. Each serial data port register 1306 contains a 32 bit register which is capable of delivering 4 bits, in a serial fashion, onto data bus 50 for delivery, for example, into the color map 40 as shown in Figure 1. The control signals 70 from the serial port control 60 are delivered into the serial state machine 1314. Which is interconnected over lines 1316 to the serial data port in order to control the serial reading of information from the dynamic latch 1304.

Hence, the dynamic latch 1304, the serial data port 1306, and the serial state machine 1314 constitute the serial port side 1210 of the dynamic video RAM 10 of the present invention.

### b Random Port Side 1200 Configuration

The random port side 1200 includes an address register 1320 which is interconnected to the random port address bus 100 and is further connected over lines 1322 (eight bits) and 1324 (five bits) to the memory block 1300. The address register 1320 is also interconnected over lines 1326 (three bits) to a block decode circuit 1330 which is interconnected over lines 1332 to the memory block 1300. The address register is also interconnected over line 1334 to the write mask 1336 and to the output control 1338.

The data register 1340 is interconnected to the data bus 90 and is further interconnected over line 1342 (H/V bit) to the memory block 1300, over lines 1344 (START - five bits) and 1346 (STOP - five bits) to the write mask 1336. The write mask 1336 is further interconnected over lines 1348 (32 bits) to the memory block 1300. The data register 1340 is further interconnected over lines 1350 (four bits) and 1352 (sixteen bits) to the drawing rule circuit 1354 which in turn is interconnected over lines 1356 (thirty-two bits) to the memory block 1300.

The output control 1338 is also interconnected to the random port data bus 90 and is also interconnected over lines 1358 to the memory block 1300. Destination latch 1360 is also connected to lines 1358 and is further connected over lines 1362 (thirty-two bits) to the drawing rule circuit 1354 and over line 1364 to the random state machine 1366. The random state machine 1366 receives the random port control input signals over random port control bus 140.

Hence, the address register 1320, the block decode circuit 1330, the data register 1340, the write mask 1336, the output control 1338, the drawing rule circuit 1354, the destination latch 1360, and the random state machine 1366 constitute the random port side 1200 of the dynamic video RAM 10 of the present invention. While a preferred embodiment of the present invention is shown, variations to the design could be made under the teachings of the claimed invention. For example, the latch 1360 could be designed using strobed combinational logic to deliver or hold the stored video information.

### c. Serial Port Side 1210 Operation

The operation of the dynamic video RAM of the present invention will first be discussed with respect to the operation of the serial data transfer mode of operation wherein the information contained within the memory block 1300 is issued to generate the image, for example, on the color monitor 20 of Figure 1. This scan line transfer mode of operation utilizes the addressing techniques shown in Figures 2-4.

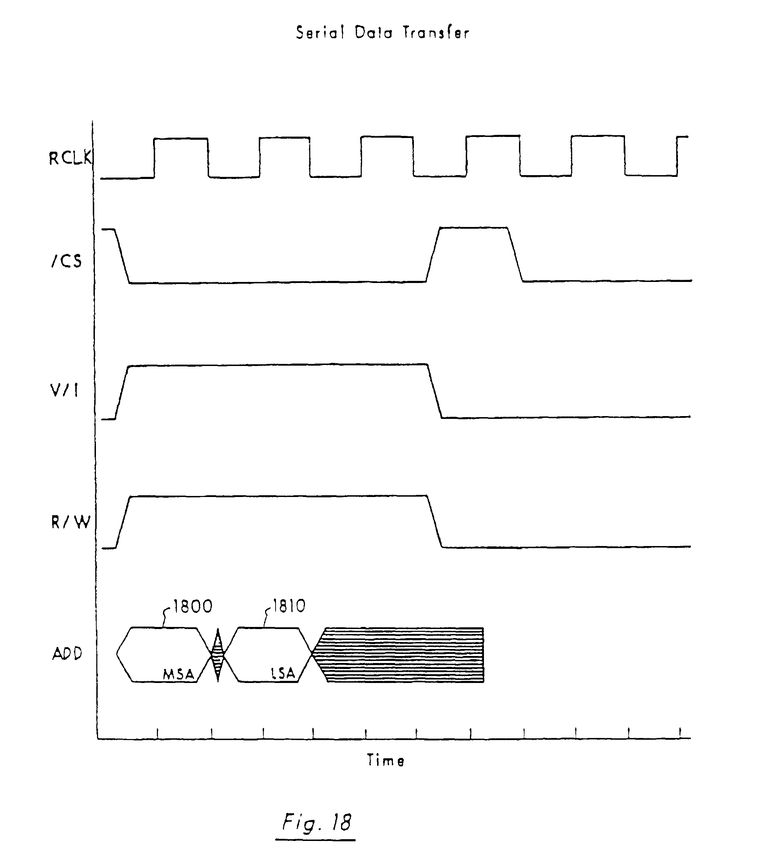

In the timing and control diagram of Figure 18, the RCLK, /CS, V/I, and R/W enables are delivered over random port control bus 140 from the random port control 120. The address, ADD, is delivered over bus 100 from the graphics hardware 110. The /CS signal selects which dynamic video RAM chip 10 is being activated. In this mode of operation, i.e., serial data transfer, the R/W bit is high to read the memory block 1300. When a serial data transfer occurs, the V/I bit set high (see Table I) (i.e., vector or image) is also selected and as shown in Table I the vector mode is selected. Hence, the address (MSA and LSA) of the data to be transferred from the memory block 1300 to the dynamic latch 1304 is contained on bus 100 - see Figure 4. The single clock signal RCLK causes the random state machine 1366 to input the address (MSA and LSA) into the address register 1320 during a first time interval (i.e., at times 1800 and 1810) as shown in Figure 18. When it is desired to read the memory block 1300 so that the contents can be serially delivered to the color map 40, the transfer of the addressed partial scan line for a screen refresh occurs in the following manner. Thirty two bits of information from each of the eight memory blocks 1300 are read over lines 1302 into the dynamic latches 1304. The dynamic latch 1304 receives a signal over line EN-DL from the random state machine 1366 indicating that it is to read the data from the memory block. All eight dynamic latches are so enabled and each will read in 32 bits for a 256 bit partial scan line. After reading, EN-DL is appropriately activated to deliver the read information over lines 1308 into the serial data port 1306. Again, this is a parallel transfer of 32 bits of information for each of the eight serial shift registers. The serial data port 1306 comprises shift registers. Each of the eight serial data ports 1306 is under control of the serial state machine 1314 and the serial clock SCLK. When the serial data port 1306 is enabled over line SL, each clock signal transfers out four bits from a given serial data port 1306 to data bus 50.

The transfer of the data occurs in the following fashion. Serial state machine 1314 has a counter contained therein which counts the serial clock pulses SCLK. Hence, as the SCLK pulses come in, they are delivered to the serial data port 1306 which after eight such pulses sequentially gates out the 32 bits stored therein, four bits at a time, to the video data bus 50. Then, the next eight SCLK pulses cause the output of the 32 bits out from that next memory block portion to the video data bus 50. In this fashion, the serial state machine 1314 is capable of causing the serial data port to output the stored data from each of serial data port 1306 until a partial scan line is output from the serial data port 1306. After a partial scan line is output, a /LOAD signal is received over serial port control bus 70 to the serial state machine 1314 and over line 1316 to load from the dynamic latch all of the serial data port 1306 with the data for the next partial scan line. The /SOE input to serial data port 1306 enables the multiplexer to deliver the information four bits at a time to the color map 40.

It is to be expressly understood that other conventional configurations for the serial port could be utilized under the teachings of the present invention. The serial port is asynchronous from the random port and can transfer data over bus 50 while the chip 10 is performing other operations.

### d. Random Port Side 1200 Operation

The operation of the random port 1200 of the dynamic video RAM 10 will now be explained.

The term "drawing rule" is defined to be a logical operator combining a "source" and a "destination" upon write to the memory block 1300. Drawing rules, in the preferred embodiment, are specified by the following table:

**TABLE III**

| Drawing Rule | Product |
|---|---|
| 0000 | clear (all zeroes) |
| 0001 | source and destination |
| 0010 | source and (not destination) |
| 0011 | source |
| | |
| 0100 | (not source) and destination |
| 0101 | destination |
| 0110 | source xor destination |
| 0111 | source or destination |
| | |
| 1000 | source nor destination |
| 1001 | source nxor destination |
| 1010 | not destination |
| 1011 | source or (not destination) |
| | |
| 1100 | not source |
| 1101 | (not source) or destination |
| 1110 | source nand destination |
| 1111 | set (all ones) |

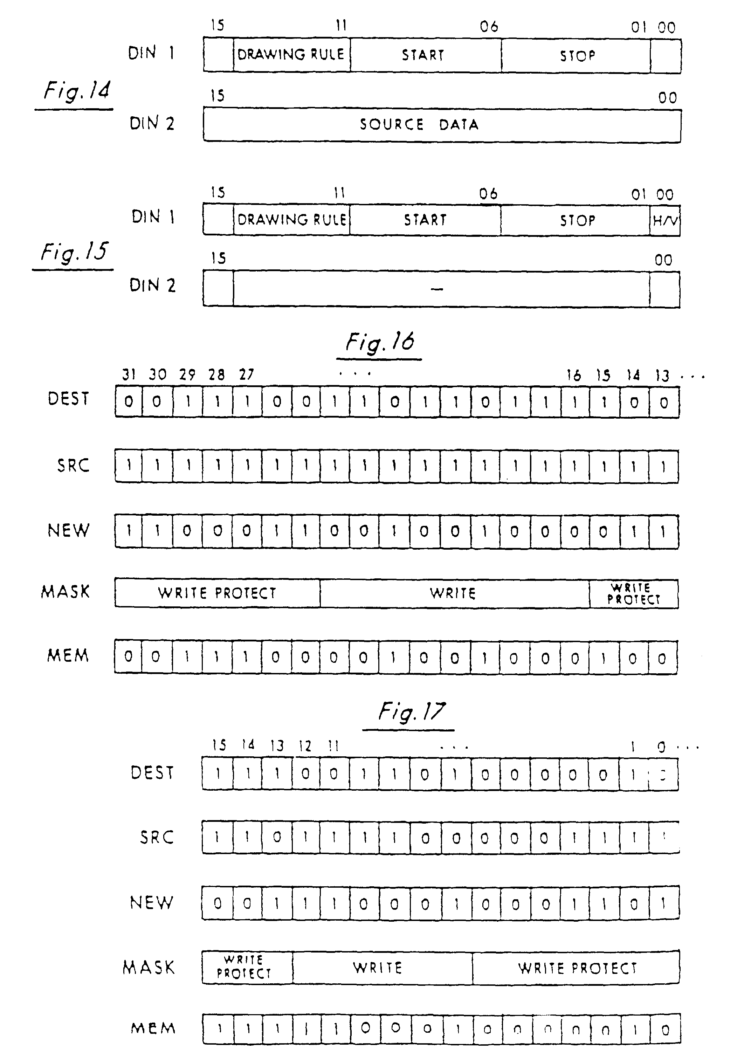

The operation of this table will be discussed in the following. In addition, the present invention incorporates two data cycles termed DIN1 and DIN2. In Figure 14, DIN1 and DIN2 are shown for the image mode of operation. Figure 15 shows DIN1 and DIN2 for the vector mode of operation.

Under the teachings of the present invention, the drawing rule function is incorporated directly in the dynamic video RAM chip 10. This permits faster modification of data within the memory block 1300. Conventional video RAM designs require that the information in the memory block be read out of the video RAM chip and be modified in another chip or circuit. After modification off the chip, it is rewritten back into the memory block. This is a slow process.

Under the teachings of the present invention up to 32 pixel elements can be changed in one operation. Conventional approaches use the image mode of operation whereas the present invention also incorporates the vector mode of operation wherein a horizontal or vertical vector in a defined page can be modified and changed according to the selected drawing rule. This feature significantly speeds up the time for modification of the information contained in the memory block. For example, if under a conventional approach, a vertical line from screen 200 is to be modified, a number of horizontal scan lines would have to be read out of the memory in order to modify the one bit corresponding to the vertical line. Under the teachings of the present invention, only one vertical vector would have to be accessed and modified significantly increasing the performance of the system over conventional approaches. It is estimated that current video RAM systems can process these vectors at the rate of 300,000 to 700,000 vectors per second. Under the teachings of the present invention, three to four million horizontal and vertical vectors per second can be processed.

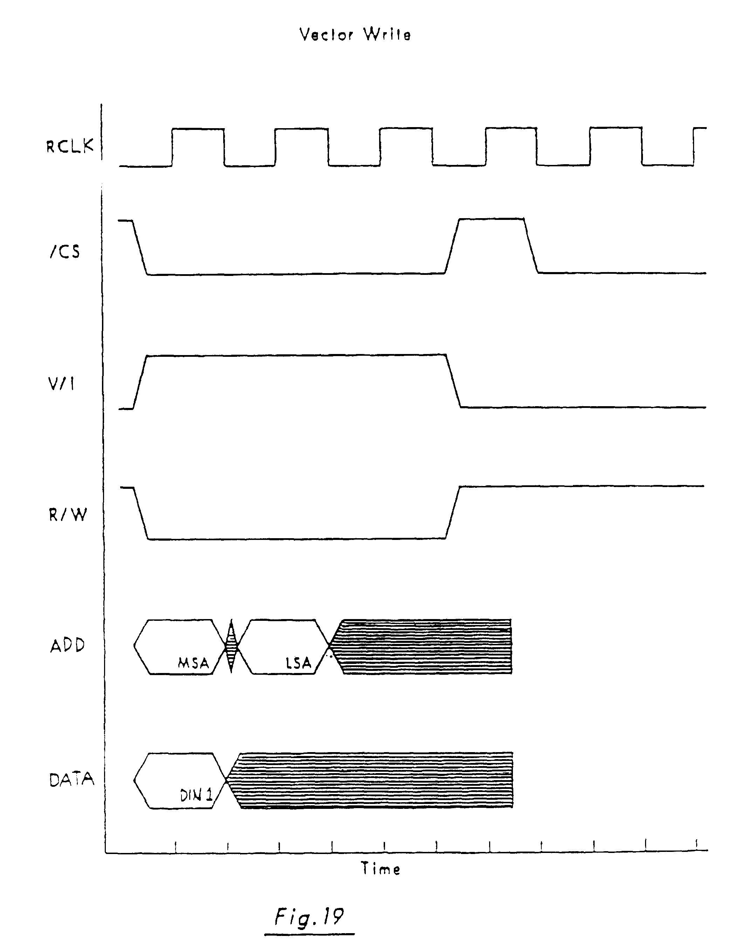

The speed up is due to the provision of the vector write mode of operation as will be discussed in the following. In the vector write mode of operation, the MSA and LSA addresses of Figure 8 are sequentially loaded into the address register 1320. This is shown in the timing diagram of Figure 19 where the /CS selects the proper chip, the V/I lead is high to select the vector mode, and R/W is low for write. Hence, the MSA and LSA of the address (Figure 8) are loaded into the address register 1320 as well as the drawing rule, start, and stop (Figure 15) over the random port data bus 90 into the data register 1340. The vector address (MSA and LSA) and the data (DIN1) is delivered during a first time interval.

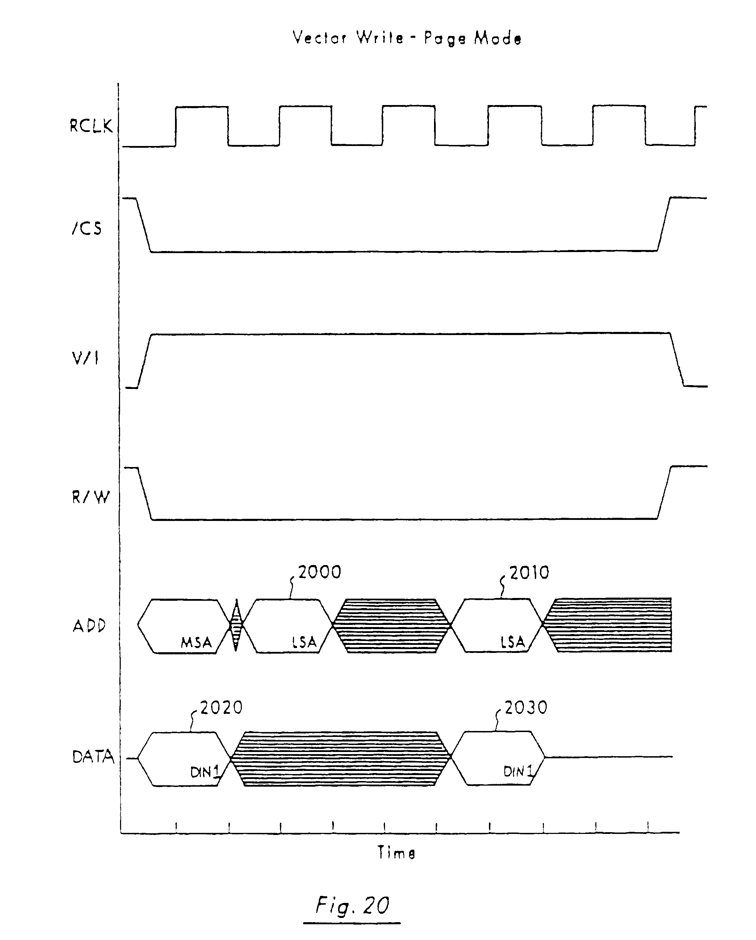

In Figure 20, the timing for vector write, page mode is shown. Here, the MSA remains the same whereas the LSA and the DIN are changed at times 2000 and 2010 for the LSA and time 2020 and 2030 for the DIN1. The MSA and LSA addresses containing the page row, page column and vector identification of Figure 8 are stored into the address register 1320. Eight bit outputs are delivered over lines 1322 to address the memory row of memory block 1300, five of the bits are delivered over lines 1324 to address the memory column of memory block 1300, and the three remaining bits are delivered over lines 1326 to the block decode circuitry 1330. The block decode circuitry 1330 is simply a one out of eight decode to selectively activate one of the eight memory blocks 1300.

In the vector mode of operation, DIN1 as shown in Figure 15 is read into the data register 1340 over data bus 90. DIN2 is not used in this mode. The five START bits are delivered over lines 1344 to the write mask 1336 and the five STOP bits are delivered over lines 1346 to the write mask 1336. The four drawing rule bits are delivered over lines 1350 to the drawing rule circuit 1354. The H/V bit is delivered from the data register 1340 over line 1342 to the memory block 1300.

The address register is of conventional register design that enables data to be read from a bus and to store the information in the register. The address register is enabled to read the most significant address by the MSA enable and the least significant address by the LSA enable. Likewise, the data register 1340 is of conventional design and reads in data from the data bus 90 and stores it internally upon being selectively enabled by the DIN1 and DIN2 enable lines. At this point and time, the address register 1320 and the data register 1340 have the necessary vector information to identify either a horizontal or vertical vector to perform a drawing rule operation on it. Other circuits could be designed to perform the above described address and data functions.

In reference back to Figures 5-8, it is seen that a selected vertical 600 or horizontal 610 vector is composed of 32 pixel elements or when resident in the memory block 1300, 32 memory cells. The START and STOP information conveys the precise portion of the vector to be modified according to the drawing rule. For example, if the desired place to start the modification within a vector is seven bits from the start of the vector, the START command would be 00111 and if the STOP location is the fifteenth bit, the STOP command would be 01111. The START and STOP information is delivered to the write mask which provides 32 possible write protect WP signals over lines 1348. Hence, in our example of starting at location 7 and stopping at location 15 in a 32 bit vector, the first seven bits would be activated in the write protect mode and the last sixteen bits would be activated in the write protect mode so that when NEW data is read back into memory over lines 1356 only the desired portion of memory cells between the START and STOP locations are written into the memory.

In Figure 16 is shown an example of performing a drawing rule operation in the vector write page mode. The address register 1320 addresses a specific horizontal or vertical vector in the memory block 1300. Whether or not the vector is horizontal or vertical is determined by the H/V signal on line 1342 which is the first bit in DIN1 of Figure 15. The OLD information is read out of the memory block on line 1358 and in Figure 16 is designated DEST for "destination". It is to be noted that information could be delivered through the output control 1338 to data bus 90 for delivery back into the system if desired or into the destination latch 1360. The appropriate enable signal DEST on line 1364 enables the destination latch 1360 to read in the OLD information. All 32 bits of the destination information of Figure 16 are read into the latch 1360. The output 1362 of the destination latch 1360 is delivered as the destination input to the drawing rule circuit 1354. For vector mode operation, the SOURCE (SRC) signals on lines 1352 from the data register 1340 are set to all ones and are shown in Figure 16. The drawing rules are set forth in TABLE III.

In the example of Figure 16, the "not destination" drawing rule 1010 appears in the data register 1340. Hence, the OLD information or destination data DEST is inverted to result in a new modified vector which is termed NEW as shown in Figure 16. However, the writing of this information into the memory block occurs under control of the write mask 1336 and as previously explained, for our example, bits 31-26 and 15-0 are write protected. Only bits 25-16 of the NEW data can be written into memory. In a similar fashion, all of the logical functions of the drawings rules can be implemented for the entire vector or a portion thereof based upon the START and STOP information.

In the vector mode of operation, up to 32 pixel elements stored in memory block 1300 can be changed in one operation on chip. The present invention is capable of changing a vector located either horizontally or vertically as shown in Figure 6 through use of the H/V bit.

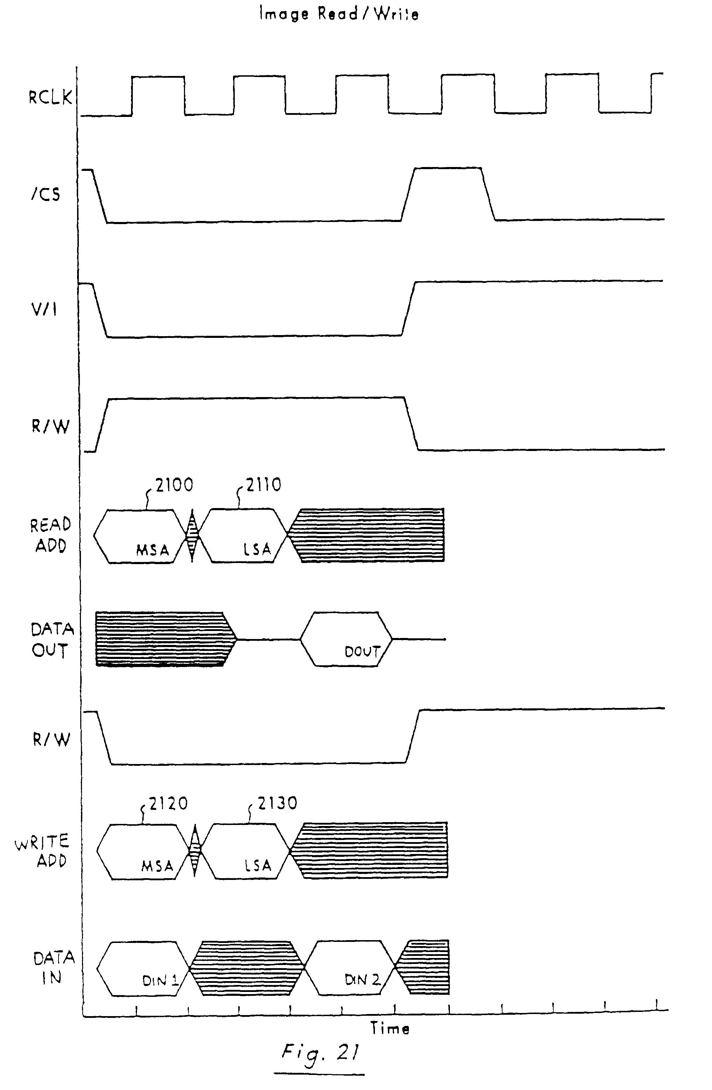

In the image mode of operation, the MSA and LSA addresses of Figure 11 are utilized. In Figure 21, the timing for both image read and image write is shown. Again /CS is properly enabled, and V/I is set low for the image mode. When R/W is set high for read, the read address (MSA 2100 and LSA 2110) is delivered over bus 100 and the data DOUT is read out over bus 90. When R/W is set low for write, the write address (MSA 2120 and LSA 2130) is delivered over bus 100 and the data DIN1 + DIN2 is delivered to the chip over bus 90. Here, the address and DIN1 (i.e., drawing rule and START/STOP) are delivered during the first time interval and DIN2 (i.e., source data) is delivered during the second time interval.

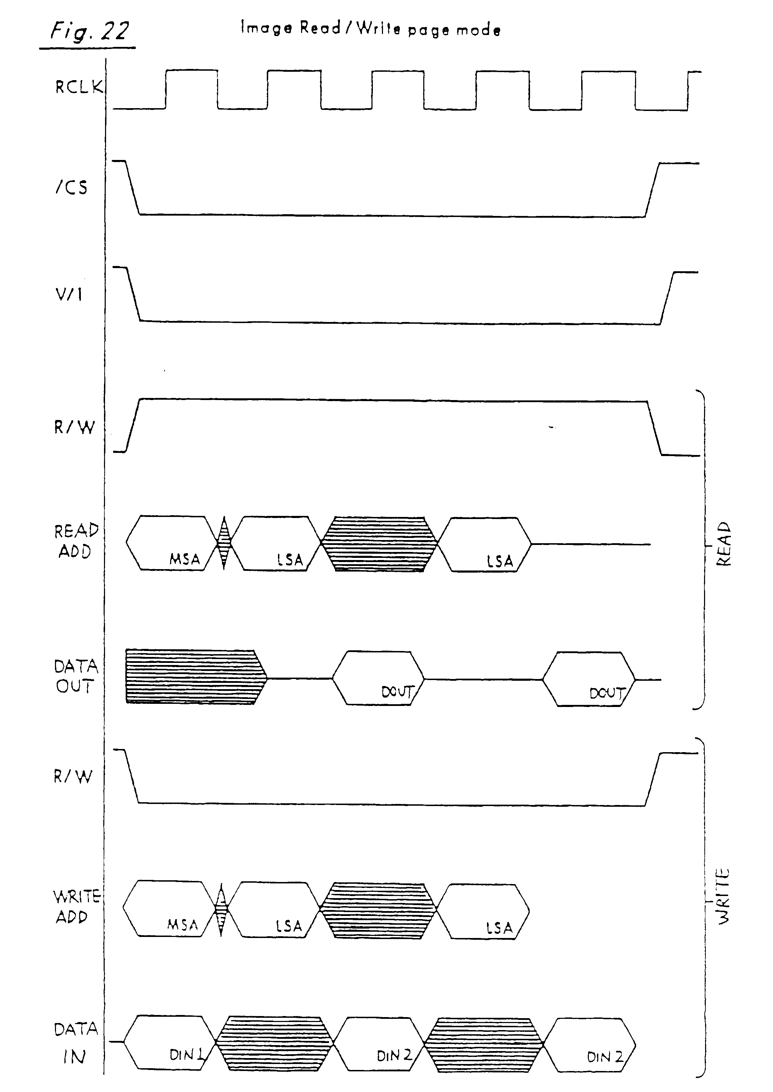

Figure 22 shows the timing for the image read and write in the page mode. In the page mode, the LSA portion of the address changes. Hence, when reading, the changing of LSA causes new data DOUT to be read out. When writing R/W is low, new data is delivered right after delivery of the LSA.

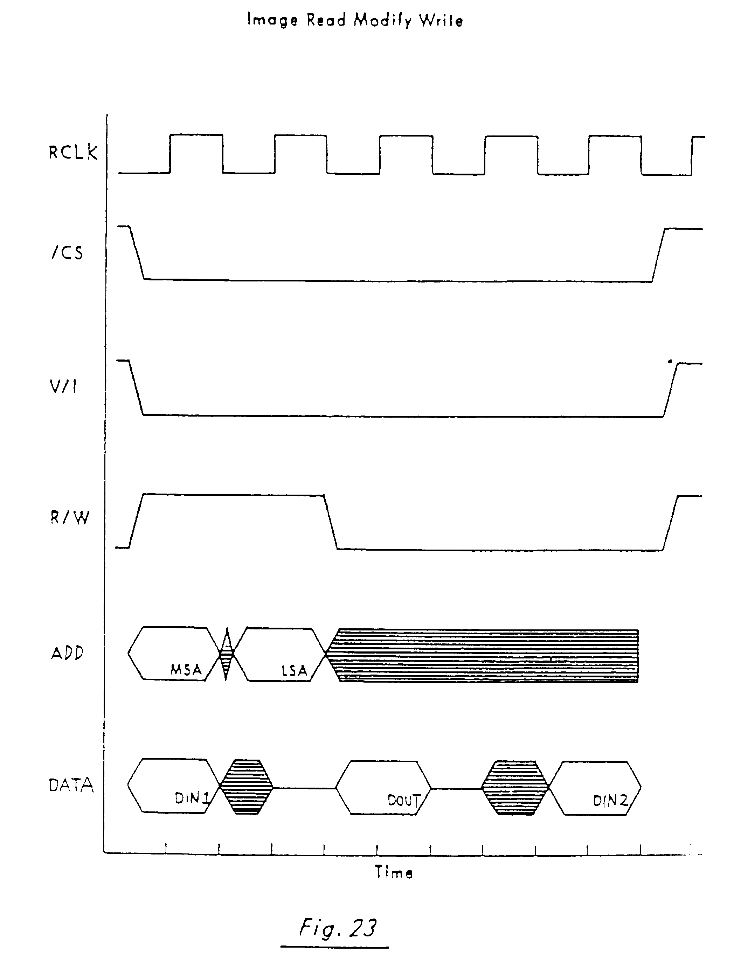

Finally, Figure 23 shows the timing for image read modify write wherein DIN1 of Figure 14 delivers the start, stop and drawing rule, DOUT is the data at the addressed location and DIN2 is the SOURCE data to be read into the chips. As before, the MSA and LSA are read into the address register 1320 and the corresponding DIN1 and DIN2 data configurations in Figure 14 are read into the data register 1340. In image mode of operation, a 16 bit word from a scan line is read from the memory block 1300 and is delivered into the destination latch 1360.

In Figure 17 is an example of a word called DEST read as OLD information from the memory block 1300. In the image mode operation, source data is delivered on DIN2 as shown in Figure 14 and designated SRC. Figure 17 shows an example of source data. This 16 bit source data SRC is delivered over lines 1352 into the drawing rule circuit 1354. If a drawing rule such as "exclusive-or" (DR = 0110) is utilized, circuit 1354 outputs on leads 1356 the NEW word as shown, in Figure 17. Again, the image mode of operation can have a START and STOP location within the word and for masking purposes. In the example assume START equals 0011 and STOP equals 1000. Hence, the mask circuit 1336 provides write protect WP for the bits indicated as in MASK in Figure 17. What is written into memory is shown as NEW in Figure 17. The present invention is capable of performing drawing rule operations on chip in the image mode of operation.

As discussed above and as shown in Figure 23, the present invention delivers the drawing rule to integrated circuit chip with the delivery of the address during the same time interval and concurrently with the address cycle. This provides a significant speed up over the Hitachi approach which requires a separate time interval in which to deliver the drawing rule.

In the serial data transfer mode of operation, the MSA and LSA addresses of Figure 4 are utilized and read into the address register 1320. As set forth in TABLE II above, there are no corresponding DIN1 or DIN2 data words. When these MSA and LSA address words are read in, the appropriate scan line and scan line portion are read from the memory block 1300 into the dynamic latch 1304 as previously discussed.

The random state machine 1366 is of conventional design and based upon the incoming set of control enables (i.e., V/I, R/W, RFRSH, and /CS) delivers, according to the pulses of the single clock RCLK, the following internal random port enable pulses: (1) EN-MSA and CLK-LSA to enable the reading of the most significant and least significant addresses on address bus 100 into the address register 1320, (2) CLK-DIN1 and EN-DIN2 to read in the data appearing on bus 90 into the data register 1340, (3) DEST to enable the destination latch 1360, (4) PRECH to pre-charge each of the memory blocks 1300 in a conventional fashion, (5) EN-DL to enable the dynamic latch 1304 to read in data from the memory block 1300, (6) /WE to enable the WRITE mask 1336 to write protect the memory block 1300 based upon the START and STOP information, (7) ALL to access all of the memory blocks rather than a particular block as specified by the block select portion of the address (this is asserted during all regular and serial data transfer cycles), and (8) the OE signal which enables the output control 1338 to output data onto the data bus 90. While the preferred embodiment uses these internal enables other enables could be used in variations on this approach.

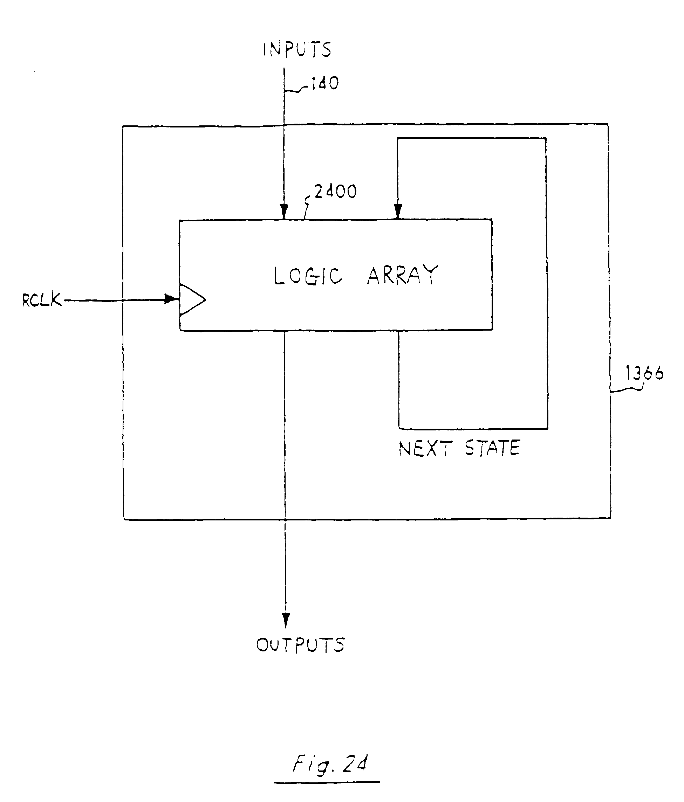

The random port state machine 1360 can comprise, for example, a programmable logic array shown in Figure 24 wherein the inputs 140 (i.e., a set of control enables) based upon the use of only a single clock RCLK to generate the outputs set forth above. Internal to the random state machine 1366 is a next state for the logic array 2400. The next state table is set forth as Table IV.

**TABLE IV**

| Input 3210 | State 3210 | Next State 3210 | Input 3210 | State 3210 | Next State 3210 | Input 3210 | State 3210 | Next State 3210 |
|---|---|---|---|---|---|---|---|---|
| 00xx | 0000 | 0100 | 0101 | 0000 | 1000 | 0111 | 0000 | 0001 |
| 00xx | 0001 | xxxx | 0101 | 0001 | xxxx | 0111 | 0001 | 0011 |
| 00xx | 0010 | xxxx | 0101 | 0010 | xxxx | 0111 | 0010 | 0000 |
| 00xx | 0011 | xxxx | 0101 | 0011 | xxxx | 0111 | 0011 | 0010 |
| 00xx | 0100 | 0110 | 0101 | 0100 | xxxx | 0111 | 0100 | xxxx |
| 00xx | 0101 | xxxx | 0101 | 0101 | xxxx | 0111 | 0101 | xxxx |
| 00xx | 0110 | 0111 | 0101 | 0110 | xxxx | 0111 | 0110 | xxxx |
| 00xx | 0111 | 0000 | 0101 | 0111 | xxxx | 0111 | 0111 | xxxx |
| 00xx | 1000 | xxxx | 0101 | 1000 | 1100 | 0111 | 1000 | xxxx |
| 00xx | 1001 | xxxx | 0101 | 1001 | 1011 | 0111 | 1001 | xxxx |
| 00xx | 1010 | xxxx | 0101 | 1010 | xxxx | 0111 | 1010 | xxxx |
| 00xx | 1011 | xxxx | 0101 | 1011 | 1100 | 0111 | 1011 | xxxx |
| 00xx | 1100 | xxxx | 0101 | 1100 | 1101 | 0111 | 1100 | xxxx |
| 00xx | 1101 | xxxx | 0101 | 1101 | 1100 | 0111 | 1101 | xxxx |
| 00xx | 1110 | xxxx | 0101 | 1110 | xxxx | 0111 | 1110 | xxxx |
| 00xx | 1111 | xxxx | 0101 | 1111 | 1011 | 0111 | 1111 | xxxx |
| | | | | | | | | |
| 0100 | 0000 | 1000 | 0110 | 0000 | 1000 | 1xxx | 0000 | 0000 |
| 0100 | 0001 | xxxx | 0110 | 0001 | xxxx | 1xxx | 0001 | 0000 |
| 0100 | 0010 | xxxx | 0110 | 0010 | xxxx | 1xxx | 0010 | 0000 |
| 0100 | 0011 | xxxx | 0110 | 0011 | xxxx | 1xxx | 0011 | 0000 |
| 0100 | 0100 | xxxx | 0110 | 0100 | xxxx | 1xxx | 0100 | 0000 |
| 0100 | 0101 | xxxx | 0110 | 0101 | xxxx | 1xxx | 0101 | 0000 |
| 0100 | 0110 | xxxx | 0110 | 0110 | xxxx | 1xxx | 0110 | 0000 |
| 0100 | 0111 | xxxx | 0110 | 0111 | xxxx | 1xxx | 0111 | 0000 |
| 0100 | 1000 | 1001 | 0110 | 1000 | 1001 | 1xxx | 1000 | 0000 |
| 0100 | 1001 | 1011 | 0110 | 1001 | 1011 | 1xxx | 1001 | 0000 |
| 0100 | 1010 | xxxx | 0110 | 1010 | xxxx | 1xxx | 1010 | 0000 |
| 0100 | 1011 | 1001 | 0110 | 1011 | 1111 | 1xxx | 1011 | 0000 |
| 0100 | 1100 | 1101 | 0110 | 1100 | 1101 | 1xxx | 1100 | 0000 |
| 0100 | 1101 | 1001 | 0110 | 1101 | 1001 | 1xxx | 1101 | 0000 |
| 0100 | 1110 | xxxx | 0110 | 1110 | xxxx | 1xxx | 1110 | 0000 |
| 0100 | 1111 | 1011 | 0110 | 1111 | 1011 | lxxx | 1111 | 0000 |
| Input₃ N_CS | | | | | | | | |
| Input₂ N_RFRSH | | | | | | | | |
| Input₁ V_I | | | | | | | | |
| Input₀ R_W | | | | | | | | |

In Table IV the input set format is: /CS, RFRSH, V/I, and R/W. As can be seen above for each different set of enables (INPUT) from the control bus 140, the random state machine produces a predetermined sequence as derived from the clock (RCLK) signal of the state table (STATE) to produce the control pulses which are defined next.

The output STATE signals are decoded from the state and are set forth in Table V.

**TABLE V**

| State 3210 | Output | | | | | | | | | | |
|---|---|---|---|---|---|---|---|---|---|---|---|
| | 10 | 9 | 8 | 7 | 6 | 5 | 4 | 3 | 2 | 1 | 0 |
| 0000 | 1 | 1 | x | 0 | x | x | 1 | 1 | 0 | 1 | 0 |
| 0001 | 0 | 0 | 0 | x | x | x | 1 | 1 | 1 | 1 | 0 |
| 0010 | 0 | 0 | x | x | x | x | 1 | 1 | 1 | 1 | 0 |
| 0011 | 0 | 0 | 1 | x | x | x | 1 | 1 | 1 | 1 | 1 |
| | | | | | | | | | | | |
| 0100 | 0 | x | x | x | x | x | 1 | 1 | 1 | 0 | 0 |
| 0101 | x | x | x | x | x | x | x | 1 | x | x | x |
| 0110 | 0 | x | x | x | x | x | 1 | 1 | 1 | 0 | 0 |
| 0111 | 0 | x | x | x | x | x | 1 | 1 | 1 | 0 | 0 |
| | | | | | | | | | | | |
| 1000 | 0 | 0 | 0 | 1 | x | x | 1 | 1 | 0 | 1 | 0 |
| 1001 | 0 | 0 | 1 | 0 | 1 | 1 | 1 | 1 | 0 | 1 | 0 |
| 1010 | x | x | x | x | x | x | x | 1 | x | x | x |
| 1011 | 0 | 0 | 0 | 0 | 0 | 0 | 0 | 1 | 0 | 1 | 0 |
| | | | | | | | | | | | |
| 1100 | 0 | 0 | 1 | 0 | x | x | 1 | 0 | 0 | 1 | 0 |
| 1101 | 0 | 0 | 0 | 0 | x | x | 1 | 1 | 0 | 1 | 0 |
| 1110 | x | x | x | x | x | x | x | 1 | x | x | x |
| 1111 | 0 | 0 | 1 | 1 | x | 1 | 1 | 1 | 0 | 1 | 0 |

The output relationships are set forth in Table VI.

**TABLE VI**

| | |
|---|---|
| Output₁₀ | PRECHARG |
| Output₉ | EN_MSA |
| Output₈ | CLK_LSA |
| Output₇ | CLK_DIN1 |
| Output₆ | EN_DIN2 |
| Output₅ | EN_DEST |
| Output₄ | N_WE |
| Output₃ | N_OE |
| Output₂ | ALL |
| Output₁ | N_IRFRSH |
| Output₀ | EN_DL |

The random port control signals set forth in Table VI become valid in the random port 1200, as shown in Figures 18 through 23 with the edges of the clock RCLK.

It can clearly be seen based upon this disclosure only a single clock pulse RCLK controls the random port 1200 of the present invention. In other words, the random port 1200 of the present invention receives a set of control signals (i.e., INPUT of Table IV). Each set corresponding to a different mode of operation for the random port. The random state machine 1366 provides the sequential configuration (i.e., STATE and NEXT STATE of Table IV) for the received set. Each different set has a different sequential configuration resulting in its own predetermined sequence of internal control pulses (i.e., Table V). The single random port clock provides the timing signal necessary for executing the configured sequence of internal control pulses so that the random port operates in the mode of operation corresponding to the received set of control signals. It is to be expressly understood that while a preferred approach is set forth in Tables IV, V, and VI that other configurations of control signals and states can be defined under the teachings of the present invention to work on the provision of a single random port clock which in the present embodiment is 16.7 MHz.

Combining the aforesaid state tables with the timing diagrams of Figures 19 through 23, the method of modifying the stored information in the memory is based upon a series of time intervals which are derived from the single random clock RCLK. During a first time interval, the vector or image address as well as the drawing rule and the START and STOP locations are delivered to the chip. Based upon the set of control enables, the RCLK then sequences through the appropriate state table. Hence, during a second time interval, the addressed information is delivered from memory and the source data is delivered to the chip. During a third interval, the delivered information (i.e., DEST in Figures 16 and 17) is modified with the source data (i.e., SRC of Figures 16 and 17) based upon the drawing rule (i.e., Table III). During a fourth time interval, the modified information (i.e., NEW of Figures 16 and 17) is written between the START and STOP bit locations (i.e., MASK of Figures 16 and 17) into memory. Variations to this method are possible under the teachings of the present invention.

It is to be expressly understood that the preferred embodiment illustrates certain bit fields and patterns, certain pin configurations and layouts; however, the present invention is not so limited that under the teachings of the present invention other embodiments could be used.

While preferred embodiments of the present invention have been shown, it is to be expressly understood that modifications and changes may be made thereto and that the present invention is set forth in the following claims.

It is understood that various other modifications will be apparent to and can be readily made by those skilled in the art without departing from of this invention. Accordingly, it is not intended that the scope of the claims appended hereto be limited to the description as set forth herein.

## Claims

1. A dynamic random access memory integrated circuit comprising:
a) a memory block (1300) including a plurality of memory cells for storing information;
b) an input (1200) for receiving an external clock signal (RCLK); and
c) address input means (1320) for receiving a first address (MSA) and a second address (LSA) defining a location of information stored in said memory block (1300),
**characterized in that**
d) said dynamic random access memory integrated circuit is a synchronous circuit;
e) said address input means (1320) providing said first address (MSA) as an output in response to a first edge of said external clock signal (RCLK), said address input means (1320) providing said second address (LSA) as an output in response to a second edge of said external clock signal (RCLK); and in that
f) access means (1330) is provided for accessing a location in said memory block (1300) corresponding to said first address (MSA) and said second address (LSA) provided by said address input means (1320); and
g) control means (1366) is provided for outputting internal control signals defining timings of internal operations of said dynamic random access memory in response to an external control input on an edge of said external clock signal (RCLK), wherein a logic level of each of said internal control signals is determined concurrently in response to the same edge of said external clock signal (RCLK).

2. The memory of claim 1, characterized in that, said access means (1330, 1338) comprises output means (1338) for outputting information stored at said location of said memory block (1300) in response to a third edge of said external clock signal (RCLK).

3. The memory of claim 2, characterized in that
said control means (1366) is for supplying a first enable signal (EN_MSA) and a second enable signal (CLK_LSA) to said address input means (1320) in response to an external control input (V/I, R/W, RFRSH, /CS) on an edge of said external clock signal (RCLK), and for supplying an output enable signal (/OE) to said output means (1338) in response to said external control input (V/I, R/W, /RFRSH, /CS) on an edge of said external clock signal (RCLK), each of said first enable signal (EN_MSA), said second enable signal (CLK_LSA) and said output enable signal (/OE) being synchronous with an edge of said external clock signal (RCLK),
wherein said address input means (1320) provides said first address (MSA) in response to said first enable signal (EN_MSA), said address input means (1320) provides said second address (LSA) in response to said second enable signal (CLK_LSA), and said output means (1338) outputs said information in response to said output enable signal (/OE).

4. The memory of claim 1, characterized in that said access means (1330, 1340, 1336, 1354) comprises:
data input means (1340) for receiving data, said data input means (1340) providing said data as an output in response to a fourth edge of said external clock signal; and
write means (1336, 1354) for writing said data to said memory block (1300) at a location addressed by said first address and said second address in response to a fifth edge of said external clock signal (e.g. Fig. 22).

5. The memory of claim 4, characterized in that
said control means (1366) is for supplying a data enable signal (CLK_DIN1, EN_DIN2) to said data input means (1340) in response to an external control input (V/I, R/W, /RFRSH, /CS) on an edge of said external clock signal (RCLK), and for supplying a write enable signal (/WE) to said write means (1336, 1354) in response to said external control input (V/I, R/W, /RFRSH, /CS) on an edge of said external clock signal (RCLK), each of said data enable signal (CLK_DINT, EN_DIN2) and said write enable signal (/WE) being synchronous with an edge of said external clock signal (RCLK),
wherein said data input means (1340) provides said data in response to said data enable signal (CLK_DIN1, EN_DIN2), and said write means (1336, 1354) writes said data in response to said write enable signal (/WE).

6. The memory of claim 5, characterized in that said external clock signal (RCLK) has a frequency of about 16.7 MHz.

7. The memory of claim 1, characterized in that a serial port (1210) is provided including:
means (1314) for receiving a serial port clock signal (SCLK) for controlling timing of said serial port (1210);
serial output means (1306); and
transfer means (1304) for transferring serial information stored in said memory block (1300) to said serial output means (1306) in response to a third edge of said external clock signal (RCLK);
wherein said serial output means (1306) sequentially outputs portions of said serial information in response to respective edges of said serial port clock signal (SLCK).

8. The memory of claim 7, characterized in that
said control means (1366) is for supplying a first enable signal (EN_MSA) and a second enable signal (CLK_LSA) to said address input means (1320) in response to an external control input (V/I, R/W, /RFRSH, /CS) on an edge of said external clock signal (RCLK), and for supplying a transfer enable signal (EN_DL) to said transfer means (1304) in response to said external control input (V/I, R/W, /RFRSH, /CS) on an edge of said external clock signal (RCLK), each of said first enable signal (EN_MSA), said second enable signal (CLK_LSA) and said transfer enable signal (EN_DL) being synchronous with an edge of said external clock signal (RCLK),
wherein said address input means (1320) provides said first address (MSA) in response to said first enable signal (EN_MSA), said address input means provides said second address in response to said second enable signal, and said transfer means (1304) transfers said serial information in response to said transfer enable signal (EN_DL).

9. The memory of claim 1, characterized in that said edges occur in consecutive clock cycles.

10. A method for accessing a dynamic random access memory integrated circuit including a memory block (1300) having a plurality of memory cells for storing information; address input means (1320) for receiving a first address (MSA) and a second address (LSA) defining a location of information stored in said memory block (1300); access means (1330) for accessing said memory block (1300) and an input (1200) for receiving an external clock signal (RCLK),
**characterized in that**
said dynamic random access memory integrated circuit is a synchronous circuit and by the steps of:
a) providing said first address (MSA) as an output of said address input means (1320) in response to a first edge of said external clock signal (RCLK);
b) providing said second address (LSA) as an output of said address input means (1320) in response to a second edge of said external clock signal (RCLK);
c) accessing a location in said memory block (1300) corresponding to said first address (MSA) and said second address (LSA) provided by said address input means (1320); and
d) outputting internal control signals defining timings of internal operations of said dynamic random access memory in response to an external control input (V/I, R/W, RFRSH, /CS) on an edge of said external clock signal (RCLK) using a control means (1366), wherein a logic level of each of said internal control signals is determined concurrently in response to the same edge of said external clock signal (RCLK).

11. The method of claim 10, characterized in that
e) said first address (MSA) is held in said address input means (1320);
f) said second address (LSA) is held in said address input means (1320); and in that
g) step c) includes outputting information stored at a location of said memory block (1300) addressed by said first address (MSA) and said second address (LSA) on a third edge of said external clock signal (RCLK).

12. The method of claim 11, further comprising the step of repeating steps f) and g).

13. The method of claim 10, characterized in that the random access memory integrated circuit includes data input means (1340) for receiving data; write means (1336, 1354) for writing said data into said memory block (1300);
said method further comprising the steps of:
e) holding said first address (MSA) in said address input means (1320);
f) holding said second address (LSA) in said address input means (1320);
g) holding said data in said data input means (1340) on an edge of said external clock signal (RCLK); and
h) writing said data into said memory block (1300) at a location addressed by said first address (MSA) and said second address (LSA) on an edge of said external clock signal (RCLK).

14. The method of claim 13, characterized by comprising the step of repeating steps f) and h).

## Patentansprüche

1. Integrierter Schaltkreis mit dynamischem Speicher mit wahlfreiem Zugriff (random access memory) mit:
a) einem Speicherblock (1300) umfassend eine Mehrzahl von Speicherzellen zum Speichern von Information;
b) einem Eingang (1200) zum Empfangen bzw. Aufnehmen eines externen bzw. äußeren Taktsignals (RCLK); und
c) einer Adresseneingabevorrichtung bzw. Adresseneingangsvorrichtung (1320) zum Empfangen bzw. Aufnehmen einer ersten Adresse (MSA) und einer zweiten Adresse (LSA), welche eine Stelle der Information definieren, welche in dem Speicherblock (1300) gespeichert ist,
**dadurch gekennzeichnet, daß**
d) der integrierte Schaltkreis mit dynamischem Speicher mit wahlfreiem Zugriff ein synchroner Schaltkreis ist;
e) die Adresseneingabevorrichtung (1320) die erste Adresse (MSA) als eine Ausgabe zur Verfügung stellt bzw. erzeugt in Reaktion auf eine erste Flanke des äußeren Taktsignals (RCLK), wobei die Adresseneingabevorrichtung (1320) die zweite Adresse (LSA) als eine Ausgabe erzeugt bzw. zur Verfügung stellt in Reaktion auf eine zweite Flanke des äußeren Taktsignals (RCLK); und dadurch, daß
f) eine Zugriffsvorrichtung (1330) vorgesehen ist zum Zugreifen auf eine Stelle in dem Speicherblock (1300) entsprechend bzw. in Abhängigkeit von der ersten Adresse (MSA) und der zweiten Adresse (LSA), welche von der Adresseneingabevorrichtung (1320) zur Verfügung gestellt bzw. erzeugt wurden; und
g) eine Regel- bzw. Steuervorrichtung (1366) vorgesehen ist zum Ausgeben eines internen bzw. inneren Regel- bzw. Steuersignals, welches die Zeitpunkte bzw. die zeitliche Abfolge von internen bzw. inneren Arbeitsvorgängen bzw. Verknüpfungen des dynamischen Speichers mit wahlfreiem Zugriff definiert in Reaktion auf eine äußere Regel- bzw. Steuereingabe bei einer Flanke des äußeren Taktsignals (RCLK), wobei ein logischer Pegel von jedem der internen Regel- bzw. Steuersignale zusammenfallend bzw. zusammentreffend bzw. gleichzeitig bestimmt bzw. festgelegt wird in Reaktion auf die gleiche Flanke des äußeren Taktsignals (RCLK).

2. Speicher nach Anspruch 1, dadurch gekennzeichnet, daß die Zugriffsvorrichtung (1330, 1338) eine Ausgabevorrichtung (1338) aufweist zum Ausgeben von Information, welche bei der Stelle des Speicherblocks (1300) gespeichert ist in Reaktion auf eine dritte Flanke des äußeren Taktsignals (RCLK).

3. Speicher nach Anspruch 2, dadurch gekennzeichnet, daß
- die Regel- bzw. Steuervorrichtung (1366) zum Erzeugen bzw. zur Verfügung stellen bzw. Zuführen eines ersten Freigabesignals (EN_MSA) und eines zweiten Freigabesignals (CLK_LSA) bei bzw. zu der Adresseneingabevorrichtung (1320) ist in Reaktion auf eine äußere Regel- bzw. Steuereingabe (V/I, R/W, RFRSH, /CS) bei einer Flanke des äußeren Taktsignals (RCLK), und zum Zuführen bzw. zur Verfügung stellen eines Ausgabefreigabesignals (/OE) zu bzw. bei der Ausgabevorrichtung (1338) in Reaktion auf die äußere Regel- bzw. Steuereingabe (V/I, R/W, /RFRSH, /CS) bei einer Flanke des äußeren Taktsignals (RCLK), wobei jedes, das erste Freigabesignal (EN_MSA), das zweite Freigabesignal (CLK_LSA) und das Ausgabefreigabesignal (/OE) synchron mit einer Flanke des äußeren Taktsignals (RCLK) sind,
- wobei die Adresseneingabevorrichtung (1320) die erste Adresse (MSA) in Reaktion auf das erste Freigabesignal (EN_MSA) erzeugt bzw. zur Verfügung stellt, wobei die Adresseneingabevorrichtung (1320) die zweite Adresse (LSA) erzeugt bzw. zur Verfügung stellt in Reaktion auf das zweite Freigabesignal (CLK_LSA), und wobei die Ausgabevorrichtung (1338) die Information in Reaktion auf das Ausgabefreigabesignal (/OE) ausgibt.

4. Speicher nach Anspruch 1, dadurch gekennzeichnet, daß die Zugriffsvorrichtung (1330, 1340, 1336, 1354) aufweist:
- eine Dateneingabevorrichtung (1340) zum Empfangen von Daten, wobei die Dateneingabevorrichtung (1340) die Daten als eine Ausgabe zur Verfügung stellt bzw. erzeugt in Reaktion auf eine vierte Flanke des äußeren Taktsignals; und
- eine Schreibvorrichtung (1336, 1354) zum Schreiben der Daten zu dem Speicherblock (1300) bei einer Stelle, welche durch die erste Adresse und die zweite Adresse adressiert ist in Reaktion auf eine fünfte Flanke des äußeren Taktsignals (z.B. Fig. 22).

5. Speicher nach Anspruch 4, dadurch gekennzeichnet, daß
- die Regel- bzw. Steuervorrichtung (1366) zum Zuführen bzw. zur Verfügung stellen eines Datenfreigabesignals (CLK_DIN1, EN_DIN2) zu bzw. bei der Dateneingabevorrichtung (1340) ist in Reaktion auf eine äußere Regel- bzw. Steuereingabe (V/I, R/W, /RFRSH, /CS) bei einer Flanke des äußeren Taktsignals (RCLK), und zum Zuführen bzw. zur Verfügung stellen eines Schreibfreigabesignals (/WE) zu der Schreibvorrichtung (1336, 1354) in Reaktion auf die äußere Regel-bzw. Steuereingabe (V/I, R/W, /RFRSH, /CS) bei einer Flanke des äußeren Taktsignals (RCLK), wobei jedes, das Datenfreigabesignal (CLK_DIN1, EN_DIN2) und das Schreibfreigabesignal (/WE) synchron mit einer Flanke des äußeren Taktsignals (RCLK) sind,
- wobei die Dateneingabevorrichtung (1340) die Daten erzeugt bzw. zur Verfügung stellt in Reaktion auf das Datenfreigabesignal (CLK_DIN1, EN_DIN2), und wobei die Schreibvorrichtung (1336, 1354) die Daten schreibt in Reaktion auf das Schreibfreigabesignal (/WE).

6. Speicher nach Anspruch 5, dadurch gekennzeichnet, daß das äußere Taktsignal (RCLK) eine Frequenz von ungefähr 16,7 MHz aufweist.

7. Speicher nach Anspruch 1, dadurch gekennzeichnet, daß ein serieller Anschluß (1210) vorgesehen ist umfassend:
- eine Vorrichtung (1314) zum Empfangen eines Taktsignals des seriellen Anschluß (SCLK) zum Regeln bzw. Steuern des Zeitablaufs bzw. der zeitlichen Abfolge des seriellen Anschluß (1210);
- eine serielle Ausgabevorrichtung (1306); und
- eine Übertragungsvorrichtung (1304) zum Übertragen der seriellen Information, welche in dem Speicherblock (1300) gespeichert ist, zu der seriellen Ausgabevorrichtung (1306) in Reaktion auf eine dritte Flanke des äußeren Taktsignals (RCLK);
- wobei die serielle Ausgabevorrichtung (1306) sequentiell bzw. aufeinanderfolgend Teile bzw. Abschnitte der seriellen Information ausgibt in Reaktion auf die jeweiligen Flanken des Taktsignals des seriellen Anschluß (SLCK).

8. Speicher nach Anspruch 7, dadurch gekennzeichnet, daß
- die Regel- bzw. Steuervorrichtung (1366) zum zur Verfügung stellen bzw. Zuführen eines ersten Freigabesignals (EN MSA) und eines zweiten Freigabesignals (CLK_LSA) bei bzw. zu der Adresseneingabevorrichtung (1320) ist in Reaktion auf eine äußere Regel- bzw. Steuereingabe (V/I, R/W, /RFRSH, /CS) bei einer Flanke des äußeren Taktsignals (RCLK) und zum zur Verfügung stellen bzw. Zuführen eines Übertragungsfreigabesignals (EN_DL) zu der Übertragungsvorrichtung (1304) in Reaktion auf die äußere Regel- bzw. Steuereingabe (V/I, R/W, RFRSH, /CS) bei einer Flanke des äußeren Taktsignals (RCLK), wobei jedes, das erste Freigabesignal (EN_MSA), das zweite Freigabesignal (CLK _LSA) und das Übertragungsfreigabesignal (EN_DL) synchron mit einer Flanke des äußeren Taktsignals (RCLK) sind,
- wobei die Adresseneingabevorrichtung (1320) die erste Adresse (MSA) in Reaktion auf das erste Freigabesignal (EN_MSA) zur Verfügung stellt bzw. erzeugt, wobei die Adresseneingabevorrichtung die zweite Adresse in Reaktion auf das zweite Freigabesignal zur Verfügung stellt bzw. erzeugt, und wobei die Übertragungsvorrichtung (1304) die serielle Information überträgt in Reaktion auf das Übertragungsfreigabesignal (EN_DL).

9. Speicher nach Anspruch 1, dadurch gekennzeichnet, daß die Flanken in aufeinanderfolgenden Taktzyklen auftreten.

10. Verfahren zum Zugreifen auf einen integrierten Schaltkreis mit dynamischen Speicher mit wahlfreiem Zugriff (random access memory) umfassend einen Speicherblock (1300) mit einer Mehrzahl von Speicherzellen zum Speichern von Information; einer Adresseneingabevorrichtung (1320) zum Empfangen einer ersten Adresse (MSA) und einer zweiten Adresse (LSA), welche eine Stelle einer Information definieren, welche in dem Speicherblock (1300) gespeichert ist; einer Zugriffsvorrichtung (1330) zum Zugreifen auf den Speicherblock (1300) und einen Eingang (1200) zum Empfangen eines äußeren Taktsignals (RCLK),
**dadurch gekennzeichnet, daß**
der integrierte Schaltkreis mit dynamischem Speicher mit wahlfreiem Zugriff ein synchroner Schaltkreis ist und durch die Schritte:
a) Erzeugen bzw. zur Verfügung stellen der ersten Adresse (MSA) als eine Ausgabe der Adresseneingabevorrichtung (1320) in Reaktion auf eine erste Flanke des äußeren Taktsignals (RCLK)
b) Erzeugen bzw. zur Verfügung stellen der zweiten Adresse (LSA) als eine Ausgabe der Adresseneingabevorrichtung (1320) in Reaktion auf eine zweite Flanke des äußeren Taktsignals (RCLK);
c) Zugreifen auf eine Stelle in dem Speicherblock (1300) entsprechend der ersten Adresse (MSA) und der zweiten Adresse (LSA), welche von der Adresseneingabevorrichtung (1320) zur Verfügung gestellt werden; und
d) Ausgeben von internen bzw. inneren Regel- bzw. Steuersignalen, welche die Zeitpunkte bzw. den Zeitablauf von internen Arbeitsvorgängen bzw. Verknüpfungen des dynamischen Speichers mit wahlfreiem Zugriff definieren bzw. festlegen in Reaktion auf eine äußere Regel- bzw. Steuereingabe (V/I, R/W; RFRSH, /CS) bei einer Flanke des äußeren Taktsignals (RCLK) unter Verwendung einer Regel- bzw. Steuervorrichtung (1366), wobei ein logischer Pegel von jedem der internen Regel-bzw. Steuersignale zusammentreffend bzw. zusammenfallend bzw. gleichzeitig bestimmt wird in Reaktion auf die gleiche Flanke des äußeren Taktsignals (RCLK).

11. Verfahren nach Anspruch 10, dadurch gekennzeichnet, daß
e) die erste Adresse (MSA) in der Adresseneingabevorrichtung (1320) gespeichert bzw. gehalten wird;
f) die zweite Adresse (LSA) in der Adresseneingabevorrichtung (1320) gespeichert bzw. gehalten wird; und dadurch daß
g) Schritt c) das Ausgeben einer Information umfaßt, welche bei einer Stelle des Speicherblocks (1300) gespeichert ist, welche durch die erste Adresse (MSA) und die zweite Adresse (LSA) bei einer dritten Flanke des äußeren Taktsignals (RCLK) adressiert ist.

12. Verfahren nach Anspruch 11, weiter aufweisend den Schritt des Wiederholens von Schritt f) und g).

13. Verfahren nach Anspruch 10, dadurch gekennzeichnet, daß der integrierte Schaltkreis mit einem Speicher mit wahlfreiem Zugriff umfaßt: eine Dateneingabevorrichtung (1340) zum Empfangen von Daten; eine Schreibvorrichtung (1336, 1354) zum Schreiben der Daten in den Speicherblock (1300);
wobei das Verfahren weiter die Schritte umfaßt:
e) Halten bzw. Speichern der ersten Adresse (MSA) in der Adresseneingabevorrichtung (1320);
f) Halten bzw. Speichern der zweiten Adresse (LSA) in der Adresseneingabevorrichtung (1320);
g) Halten bzw. Speichern der Daten in der Dateneingabevorrichtung (1340) bei einer Flanke des äußeren Taktsignals (RCLK); und
h) Schreiben der Daten in den Speicherblock (1300) bei einer Stelle, welche durch die erste Adresse (MSA) und die zweite Adresse (LSA) adressiert wird bei einer Flanke des äußeren Taktsignals (RCLK).

14. Verfahren nach Anspruch 13, dadurch gekennzeichnet, daß es den Schritt des Wiederholens der Schritte f) und h) aufweist.

## Revendications

1. Circuit intégré de mémoire vive dynamique comprenant :
a) un bloc mémoire (1300) incluant une pluralité de cellules mémoire pour mémoriser des informations ;
b) une entrée (1200) pour recevoir un signal d'horloge externe (RCLK) ; et
c) un moyen d'entrée d'adresse (1320) pour recevoir une première adresse (ADRESSE DE POIDS FORT) et une seconde adresse (ADRESSE DE POIDS FAIBLE) définissant un emplacement d'une information mémorisée dans ledit bloc mémoire (1300),
**caractérisé en ce que**
d) ledit circuit intégré de mémoire vive dynamique est un circuit synchrone ;
e) ledit moyen d'entrée d'adresse (1320) délivrant ladite première adresse (ADRESSE DE POIDS FORT) comme sortie en réponse à un premier front dudit signal d'horloge externe (RCLK), ledit moyen d'entrée d'adresse (1320) délivrant ladite seconde adresse (ADRESSE DE POIDS FAIBLE) comme une sortie en réponse à un second front dudit signal d'horloge externe (RCLK) ; et en ce qu'un moyen d'accès (1330) est prévu pour accéder à un emplacement dans ledit bloc mémoire (1300) correspondant à ladite première adresse (ADRESSE DE POIDS FORT) et à ladite seconde adresse (ADRESSE DE POIDS FAIBLE) délivrées par ledit moyen d'entrée d'adresse (1320) ; et
g) un moyen de commande (1366) est prévu pour sortir des signaux de commande interne définissant les cadencements des opérations internes de ladite mémoire vive dynamique en réponse à une entrée de commande externe sur un front dudit signal d'horloge externe (RCLK), dans lequel un niveau logique de chacun desdits signaux de commande interne est déterminé simultanément en réponse au même front dudit signal d'horloge externe (RCLK).

2. Mémoire selon la revendication 1, caractérisée en ce que, ledit moyen d'accès (1330, 1338) comprend un moyen de sortie (1338) pour sortir une information mémorisée audit emplacement dudit bloc mémoire (1300) en réponse à un troisième front dudit signal d'horloge externe (RCLK).

3. Mémoire selon la revendication 2, caractérisée en ce que
ledit moyen de commande (1366) a pour but de délivrer un premier signal de validation (EN_MSA) et un second signal de validation (CLK_LSA) audit moyen d'entrée d'adresse (1320) en réponse à une entrée de commande externe (V/I, L/E, RFRSH, /CS) sur un front dudit signal d'horloge externe (RCLK) et conçu pour délivrer un signal de validation de sortie (/OE) audit moyen de sortie (1338) en réponse à ladite entrée de commande externe (V/I, L/E, /RFRSH, /CS) sur un front dudit signal d'horloge externe (RCLK), chacun desdits premier signal de validation (EN_MSA) second signal de validation (CLK_MSA) et signal de validation de sortie (/OE) étant synchrone avec un front dudit signal d'horloge externe (RCLK),
dans laquelle ledit moyen d'entrée d'adresse (1320) délivre ladite première adresse (ADRESSE DE POIDS FORT) en réponse audit premier signal de validation (EN_MSA), ledit moyen d'entrée d'adresse (1320)délivre ladite seconde adresse (ADRESSE DE POIDS FAIBLE) en réponse audit second signal de validation (CLK_LSA) et ledit moyen de sortie (1338) sort ladite information en réponse audit signal de validation de sortie (/OE).

4. Mémoire selon la revendication 1, caractérisée en ce que ledit moyen d'accès (1330, 1340, 1336, 1354) comprend :
un moyen d'entrée de données (1340) pour recevoir les données, ledit moyen d'entrée de données (1340) délivrant lesdites données comme sortie en réponse à un quatrième front dudit signal d'horloge externe ; et
un moyen d'écriture (1336, 1354) pour écrire lesdites données dans ledit bloc mémoire (1300) à un emplacement adressé par ladite première adresse et ladite seconde adresse en réponse à un cinquième front dudit signal d'horloge externe (par exemple la Fig. 22).

5. Mémoire selon la revendication 4, caractérisée en ce que
ledit moyen de commande (1366) est conçu pour délivrer un signal de validation de données (CLK_DIN1, EN_DIN2) audit moyen d'entrée de données (1340) en réponse à une entrée de commande externe (V/I, L/E, /RFRSH, /CS) sur un front dudit signal d'horloge externe (RCLK) et conçu pour délivrer un signal de validation d'écriture (/WE) audit moyen d'écriture (1336, 1354) en réponse à ladite entrée de commande externe (V/I, L/E, /RFRSH, /CS) sur un front dudit signal d'horloge externe (RCLK), chacun desdits signaux de validation de données (CLK_DIN1, EN_DIN2) et du signal de validation d'écriture (/WE) étant synchrone avec un front dudit signal d'horloge externe (RCLK),
dans laquelle ledit moyen d'entrée de données (1340) délivre lesdites données en réponse audit signal de validation de données (CLK_DIN1, EN_DIN2) et ledit moyen d'écriture (1336, 1354) écrit lesdites dcnnées en réponse audit signal de validation d'écriture (/WE).

6. Mémoire selon la revendication 5, caractérisée en que ledit signal d'horloge externe (RCLK) a une fréquence d'environ 16,7 MHz.

7. Mémoire selon la revendication 1, caractérisée en ce qu'un accès série (1210) est prévu incluant :
un moyen (1314) pour recevoir un signal d'horloge d'accès série (SCLK) pour commander le cadencement dudit accès série (1210) ;
un moyen de sortie série (1306) ; et
un moyen de transfert (1304) pour transférer les informations série mémorisées dans ledit bloc mémoire (1300) audit moyen de sortie série (1306) en réponse à un troisième front dudit signal d'horloge externe (RCLK) ;
dans laquelle ledit moyen de sortie série (1306) sort séquentiellement des parties desdites informations série en réponse au front respectif dudit signal d'horloge d'accès série (SLCK).

8. Mémoire selon la revendication 7, caractérisée en ce que
ledit moyen de commande (1366) est conçu pour délivrer un premier signal de validation (EN_MSA) et un second signal de validation (CLK_LSA) audit moyen d'entrée d'adresse (1320) en réponse à une entrée de commande externe (V/I, L/E, /RFRSH, /CS) sur un front dudit signal d'horloge externe (RCLK) pour délivrer un signal de validation de transfert (EN_DL) audit moyen de transfert (1304) en réponse à ladite entrée de commande externe (V/I, L/E, /RFRSH, /CS) sur un front dudit signal d'horloge externe (RCLK), chacun desdits premier signal de validation (EN_MSA) second signal de validation (CLK_LSA) et signal de validation de transfert (EN_DL) étant synchrone avec un front dudit signal d'horloge externe (RCLK),
dans laquelle ledit moyen d'entrée d'adresse (1320) délivre ladite première adresse (ADRESSE DE POIDS FORT) en réponse audit premier signal de validation (EN_MSA), ledit moyen d'entrée d'adresse délivre ladite seconde adresse en réponse audit second signal de validation et ledit moyen de transfert (1304) transfère lesdites informations série en réponse audit signal de validation de transfert (EN_DL).

9. Mémoire selon la revendication 1, caractérisée en ce que lesdits fronts se produisent dans des cycles d'horloge consécutifs.

10. Procédé pour accéder à un circuit intégré de mémoire vive dynamique incluant un bloc mémoire (1300) comportant une pluralité de cellules mémoire pour mémoriser des informations ; un moyen d'entrée d'adresse (1320) pour recevoir une première adresse (ADRESSE DE POIDS FORT) et une seconde adresse (ADRESSE DE POIDS FAIBLE) définissant un emplacement d'une information mémorisée dans ledit bloc mémoire (1300) ; un moyen d'accès (1330) pour accéder audit bloc mémoire (1300) et une entrée (1200) pour recevoir un signal d'horloge externe (RCLK),
**caractérisé en ce que**
ledit circuit intégré de mémoire vive dynamique est un circuit synchrone et par les étapes consistant à :
a) délivrer ladite première adresse (ADRESSE DE POIDS FORT) comme sortie dudit moyen d'entrée d'adresse (1320) en réponse à un premier front dudit signal d'horloge externe (RCLK) ;
b) délivrer ladite seconde adresse (ADRESSE DE POIDS FAIBLE) comme une sortie dudit moyen d'entrée d'adresse (1320) en réponse à un second front dudit signal d'horloge externe (RCLK) ;
c) accéder à un emplacement dans ledit bloc mémoire (1300) correspondant à ladite première adresse (ADRESSE DE POIDS FORT) et à ladite seconde adresse (ADRESSE DE POIDS FAIBLE) délivrée par ledit moyen d'entrée d'adresse (1320) ; en
d) sortir des signaux de commande interne définissant les cadencements des opérations internes de ladite mémoire vive dynamique en réponse à une entrée de commande externe (B/I, L/E, RFRSH, /CS) sur un front dudit signal d'horloge externe (RCLK) en utilisant un moyen de commande (1366), dans lequel un niveau logique de chacun des signaux de commande interne est déterminé simultanément en réponse au même front dudit signal d'horloge externe (RCLK).

11. Procédé selon la revendication 10, caractérisé en ce que
e) ladite première adresse (ADRESSE DE POIDS FORT) est conservée dans ledit moyen d'entrée d'adresse (1320) ;
f) ladite seconde adresse (ADRESSE DE POIDS FAIBLE) est conservée dans ledit moyen d'entrée d'adresse (1320) ; et en ce que
g) l'étape c) inclut la sortie de l'information mémorisée en un emplacement dudit bloc mémoire (1300) adressé par ladite première adresse (ADRESSE DE POIDS FORT) et ladite seconde adresse (ADRESSE DE POIDS FAIBLE) sur un troisième front dudit signal d'horloge externe (RCLK).

12. Procédé selon la revendication 11, comprenant de plus l'étape consistant à répéter les étapes f) et g).

13. Procédé selon la revendication 10, caractérisé en ce que le circuit intégré de mémoire vive inclut un moyen d'entrée de données (1340) pour recevoir les données ;
un moyen d'écriture (1336, 1354) pour écrire lesdites données dans ledit bloc mémoire (1300) ;
ledit procédé comprenant de plus les étapes consistant à :
e) conserver ladite première adresse (ADRESSE DE POIDS FORT) dans ledit moyen d'entrée d'adresse (1320) ;
f) conserver ladite seconde adresse (ADRESSE DE POIDS FAIBLE) dans ledit moyen d'entrée d'adresse (1320) ;
g) conserver lesdites données dans ledit moyen d'entrée de données (1340) sur un front dudit signal d'horloge externe (RCLK) ; et
h) écrire lesdites données dans ledit bloc mémoire (1300) à un emplacement adressé par ladite première adresse (ADRESSE DE POIDS FORT) et ladite seconde adresse (ADRESSE DE POIDS FAIBLE) sur un front dudit signal d'horloge externe (RCLK).

14. Procédé selon la revendication 13, caractérisé en qu'il comprend l'étape consistant à répéter les étapes f) et h).
